# EUROPEAN PATENT APPLICATION

(11) **EP 4 746 654 A1**
(43) Date of publication of application: **20.05.2026**
(21) Application number: 25214910.9
(22) Date of filing: 11.11.2025
(51) Int. Cl.: H10K 59/122

(54) **ORGANIC LIGHT EMITTING DISPLAY AND ELECTRONIC DEVICE THEREOF**

(30) Priority: 19.11.2024 KR 20240165417
(71) Applicant: Duk San Neolux Co., Ltd., Chungcheongnam-do 31027 (KR)
(72) Inventor: LEE, Yeon Soo, Cheonan-si 31027 (KR); KIM, Jun Ki, Cheonan-si 31027 (KR); KIM, Kyung Soo, Cheonan-si 31027 (KR)
(74) Representative: Bryn Aarflot AS

(57) **Abstract**

The disclosure discloses an organic light emitting display device including a first electrode, a pixel definition layer disposed on the first electrode and exposing a portion of the first electrode through an opening, an organic material layer disposed in the opening of the pixel definition layer, and a second electrode disposed on the organic material layer, and a manufacturing method thereof, and an electronic device thereof. In this case, the pixel definition layer includes a halftone layer composed of a photosensitive composition, a trench formed in the halftone layer, and a full-tone layer protruding from the halftone layer.

## Description

### CROSS-REFERENCE TO RELATED APPLICATION

This application claims priority from Korean Patent Application No. 10-2024-0165417, filed on November 19, 2024, which is hereby incorporated by reference for all purposes as if fully set forth herein.

### BACKGROUND

### Field

The disclosure relates to an organic light emitting display device including a pixel definition layer manufactured using a photosensitive composition and an electronic device thereof.

### Description of Related Art

Flat panel display devices such as liquid crystal displays (LCD) and organic light emitting displays (OLED) are widely used. Among these, an organic light emitting display device has advantages such as low power consumption, fast response speed, high color reproducibility, high brightness, and wide viewing angle.

In the case of an organic light emitting display device, a polarizing film is used to block light that is incident from external light and reflected from the panel, but there is a disadvantage that the polarizing film is not suitable for application to flexible devices due to insufficient bending characteristics.

As a method to solve the problem, methods of forming an inorganic film for blocking light on an upper substrate as well as a color filter and a black matrix have been proposed. However, the method has limitations in obtaining a desired level of antireflection effect and does not specifically present a method for replacing the polarizing film.

Meanwhile, a coloring pattern is used not only in liquid crystal displays as red, green, and blue color filters but also in organic light emitting displays as a pixel definition layer that separates each pixel (red, green, blue).

When manufacturing a pixel definition layer, various types of organic pigments as well as carbon black and inorganic pigments are used as colorants, and a pigment dispersion in which these are dispersed is mixed with other compositions to form a pattern. In this case, before the organic light emitting layer is deposited, a photolithography process is added to support the metal mask for deposition, and then the deposition process proceeds.

An organic light emitting display composed of a pixel definition layer may implement clearer colors. However, when driving the display, lateral current may flow into the pixel through the pixel definition layer, which causes problems in color implementation, reliability, and lifespan of the organic light emitting display.

### BRIEF SUMMARY

The present embodiments provide an organic light emitting display device and a manufacturing method thereof that prevent lateral current flowing into pixels due to high lateral resistance, thereby not only making the display colors clear but also enhancing reliability and lifespan.

The present embodiment provides an electronic device including the above-described organic light emitting display device.

In one aspect, an organic light emitting display device according to an embodiment includes a first electrode, a pixel definition layer disposed on the first electrode and exposing a portion of the first electrode through an opening, an organic material layer disposed in the opening of the pixel definition layer, and a second electrode disposed on the organic material layer. In this case, the pixel definition layer includes a halftone layer composed of a photosensitive composition, a trench formed in the halftone layer, and a full-tone layer protruding from the halftone layer.

In another aspect, a method for manufacturing an organic light emitting display device according to another embodiment includes preparing a first electrode on a substrate, forming a pixel definition layer on the first electrode that exposes a portion of the first electrode through an opening, forming an organic material layer disposed in the opening of the pixel definition layer, and forming a second electrode disposed on the organic material layer.

The step of forming the pixel definition layer includes exposing a photosensitive composition applied on the first electrode using a photomask including a first section with 0% transmittance, a second section with 5% to 20% transmittance, a third section with 25% to 50% transmittance, and a fourth section with 100% transmittance to form a trench, a halftone layer, and a full-tone layer, respectively.

In yet another aspect, an electronic device according to another embodiment includes the above-described organic light emitting display device and a controller driving the organic light emitting display device.

The organic light emitting display device, its manufacturing method, and its electronic device according to the disclosure may prevent lateral current flowing into pixels by increasing lateral resistance, thereby not only making colors clear but also enhancing the reliability and lifespan of the display.

### BRIEF DESCRIPTION OF THE DRAWINGS

The above and other objects, features, and advantages of the present disclosure will be more clearly understood from the following detailed description, taken in conjunction with the accompanying drawings, in which:
FIG. 1 is a partial plan view illustrating an organic light emitting display device according to an embodiment;
FIG. 2 is a cross-sectional view illustrating an organic light emitting display device according to an embodiment;
FIG. 3 is a cross-sectional view along line A-A' of the pixel definition layer of FIG. 1;
FIGS. 4A and 4B are cross-sectional views illustrating examples of organic material layers;
FIGS. 5 to 7 show the relationship between the taper angle of each layer of the pixel definition layer and lateral current in an organic light emitting display device according to an embodiment;
FIG. 8 is a flowchart illustrating a manufacturing method of an organic light emitting display device according to another embodiment; and
FIGS. 9A and 9B show processes of forming a pixel definition layer using a multi-tone photomask in the step of forming the pixel definition layer in the manufacturing method of FIG. 8.

### DETAILED DESCRIPTION

Some embodiments of the present invention are described in detail below with reference to exemplary drawings. In assigning reference numerals to components of each drawing, the same components may be assigned the same numerals even when they are shown on different drawings.

When determined to make the subject matter of the present invention unclear, the detailed description of the known configurations or functions may be skipped. As used herein, when a component "includes," "has," or "is composed of" another component, the component may add other components unless the component "only" includes, has, or is composed of" the other component. As used herein, the singular forms "a", "an" and "the" are intended to include the plural forms as well, unless the context clearly indicates otherwise.

Further, in describing the components of the present invention, terms, such as first, second, A, B, (a), and (b), may be used. These denotations are provided merely to distinguish a component from another, and the essence, order, or number of the components are not limited by the denotations.

In describing the positional relationship between components, when two or more components are described as "connected", "coupled" or "linked", the two or more components may be directly "connected", "coupled" or "linked" ", or another component may intervene. Here, the other component may be included in one or more of the two or more components that are "connected", "coupled" or "linked" to each other.

When a component is "on" or "above" another component, it should be understood that the component may be immediately on or above the other component, or other components may intervene therebetween. In contrast, when a component is "immediately on" another component, it should be understood that no intervening component is present therebetween.

When such terms as, e.g., "after", "next to", "after", and "before", are used to describe the temporal flow relationship related to components, operation methods, and fabricating methods, it may include a non-continuous relationship unless the term "immediately" or "directly" is used.

When a component is designated with a value or its corresponding information, the value or the corresponding information may be interpreted as including a tolerance that may arise due to various factors (e.g., process factors, internal or external impacts, or noise).

The terms used in this specification and the appended claims are as follows unless otherwise mentioned, within the scope that does not deviate from the spirit of the disclosure.

The term "halo" or "halogen" used in this application includes fluorine (F), chlorine (Cl), bromine (Br), and iodine (I) unless otherwise described.

The term "alkyl" or "alkyl group" used in this application refers to a radical of saturated aliphatic functional groups having 1 to 60 carbons connected by single bonds, including straight-chain alkyl groups, branched-chain alkyl groups, cycloalkyl (alicyclic) groups, alkyl-substituted cycloalkyl groups, and cycloalkyl-substituted alkyl groups, unless otherwise described.

The term "haloalkyl group" or "halogenalkyl group" used in this application means an alkyl group substituted with halogen unless otherwise described.

The terms "alkenyl" or "alkynyl" used in this application have double bonds or triple bonds, respectively, include straight-chain or branched-chain groups, and have 2 to 60 carbon atoms unless otherwise described, but the disclosure is not limited thereto.

The term "cycloalkyl" used in this application means an alkyl forming a ring having 3 to 60 carbon atoms unless otherwise described, but the disclosure is not limited thereto.

The term "alkoxy group" or "alkyloxy group" used in this application means an alkyl group to which an oxygen radical is bonded, and has 1 to 60 carbon atoms unless otherwise described, but the disclosure is not limited thereto.

The term "alkenoxyl group," "alkenoxy group," "alkenyloxyl group," or "alkenyloxy group" used in this application means an alkenyl group with an oxygen radical attached, and has 2 to 60 carbon atoms unless otherwise described, but the disclosure is not limited thereto.

The terms "aryl group" and "arylene group" used in this application each have 6 to 60 carbon atoms unless otherwise described, but the disclosure is not limited thereto. In this application, an aryl group or arylene group includes single ring forms, ring assemblies, fused multi-ring system compounds, etc. For example, an aryl group may include a phenyl group, a monovalent functional group of biphenyl, a monovalent functional group of naphthalene, a fluorenyl group, and a substituted fluorenyl group, and an arylene group may include a fluorenylene group and a substituted fluorenylene group.

The term "ring assemblies" used in this application means that two or more ring systems (single rings or fused ring systems) are directly connected to each other through single bonds or double bonds, and the number of direct connections between such rings is one less than the total number of ring systems included in the compound. In ring assemblies, the same or different ring systems may be directly connected to each other through single bonds or double bonds.

Since the aryl group in this application includes ring assemblies, the aryl group includes biphenyl and terphenyl in which benzene rings, which are single aromatic rings, are connected by single bonds. Further, since the aryl group also includes compounds in which aromatic single rings and fused aromatic ring systems are connected by single bonds, it includes, e.g., compounds in which benzene rings, which are aromatic single rings, and fluorene, which is a fused aromatic ring system, are connected by single bonds.

The term "fused multi-ring system" used in this application means a fused ring form sharing at least two atoms, and includes forms in which two or more hydrocarbon ring systems are fused and forms in which at least one heterocyclic system including at least one heteroatom is fused. Such fused multi-ring systems may be aromatic rings, heteroaromatic rings, aliphatic rings, or combinations of these rings. For example, in the case of an aryl group, a naphthalenyl group, a phenanthrenyl group, or a fluorenyl group may be a fused polycyclic system, but is not limited thereto.

The term "spiro compound" used in this application has a 'spiro union', and spiro union means a connection made by two rings sharing only one atom. In this case, the atom shared by two rings is called a 'spiro atom', and according to the number of spiro atoms included in one compound, they are called 'monospiro-', 'dispiro-', and 'trispiro-' compounds, respectively.

The terms "fluorenyl group," "fluorenylene group," and "fluorentriyl group" used in this application mean monovalent, divalent, or trivalent functional groups in which R, R', R", and R‴ are all hydrogen in the following structure unless otherwise described, and "substituted fluorenyl group," "substituted fluorenylene group," or "substituted fluorentriyl group" means that at least one of the substituents R, R', R", R‴ is a substituent other than hydrogen, and includes cases where R and R' are bonded to each other to form a spiro compound together with the carbon to which they are bonded. In this specification, regardless of valence such as monovalent, divalent, trivalent, etc., fluorenyl group, fluorenylene group, and fluorentriyl group may all be called fluorene groups.

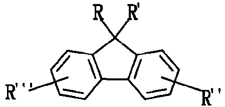

Further, R, R', R", and R‴ may each independently be an alkyl group having 1 to 20 carbon atoms, an alkenyl group having 1 to 20 carbon atoms, an aryl group having 6 to 30 carbon atoms, or a heterocyclic group having 2 to 30 carbon atoms. For example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, substituted fluorenyl groups and fluorenylene groups may each be monovalent or divalent functional groups of 9,9-dimethylfluorene, 9,9-diphenylfluorene, and 9,9'-spirobis[9H-fluorene] .

The term "heterocyclic group" used in this application includes not only aromatic rings such as "heteroaryl group" or "heteroarylene group" but also non-aromatic rings, and unless otherwise described, it means a ring having 2 to 60 carbon atoms including one or more heteroatoms, but the disclosure is not limited thereto. The term "heteroatom" used in this application represents N, O, S, P, or Si unless otherwise described, and a heterocyclic group means single ring forms, ring assemblies, fused multi-ring systems, spiro compounds, etc. including heteroatoms.

For example, "heterocyclic group" may also include compounds including heteroatom groups such as SO₂, P=O, etc. instead of carbon forming the ring, such as the following compound.

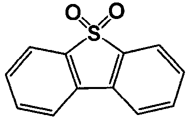

The term "ring" used in this application includes single rings and polycycles, includes not only hydrocarbon rings but also heterocycles including at least one heteroatom, and includes aromatic and non-aromatic rings.

The term "polycycle" used in this application includes ring assemblies such as biphenyl and terphenyl, fused multi-ring systems and spiro compounds, includes not only aromatic but also non-aromatic, and includes not only hydrocarbon rings but also heterocycles including at least one heteroatom.

The term "aliphatic cyclic group" used in this application means cyclic hydrocarbons excluding aromatic hydrocarbons, includes single ring forms, ring assemblies, fused multi-ring systems, spiro compounds, etc., and unless otherwise described, it means a ring having 3 to 60 carbon atoms, but the disclosure is not limited thereto. For example, even when aromatic ring benzene and non-aromatic ring cyclohexane are fused, it corresponds to an aliphatic ring.

Further, when prefixes are named consecutively, it means that substituents are listed in the order written first. For example, an arylalkoxy group means an alkoxy group substituted with an aryl group, an alkoxycarbonyl group means a carbonyl group substituted with an alkoxy group, and an arylcarbonylalkenyl group means an alkenyl group substituted with an arylcarbonyl group, where an arylcarbonyl group is a carbonyl group substituted with an aryl group.

Unless otherwise explicitly stated, in the term "substituted" or "unsubstituted" as used herein, "substituted" may mean being substituted with one or more substituents selected from the group consisting of deuterium, halogen, amino group, nitrile group, nitro group, C₁-C₃₀ alkyl group, C₁-C₃₀ alkoxy group, C₁-C₃₀ alkylamine group, C₁-C₃₀ alkylthiophene group, C₆-C₃₀ arylthiophene group, C₂-C₃₀ alkenyl group, C₂-C₃₀ alkynyl group, C₃-C₃₀ cycloalkyl group, C₆-C₃₀ aryl group, C₆-C₃₀ aryl group substituted with deuterium, C₈-C₃₀ arylalkenyl group, silane group, boron group, germanium group, and C₂-C₃₀ heterocyclic group including at least one heteroatom selected from the group consisting of O, N, S, Si and P, but is not limited to the substituents.

In this application, when the aryl group, arylene group, heterocyclic group, etc. exemplified as examples of each symbol and its substituents correspond to 'functional group names', 'names of functional groups reflecting valence' may be described, but 'parent compound names' may also be described. For example, in the case of 'phenanthrene', which is a type of aryl group, the monovalent 'group' may be described as 'phenanthryl (group)', the divalent group as 'phenanthrylene (group)', etc., distinguishing the names of groups by valence, but may also be described as 'phenanthrene', the parent compound name, regardless of valence.

Similarly, in the case of pyrimidine, it may be described as 'pyrimidine' regardless of valence, or in the case of monovalent, it may be described as pyrimidinyl (group), and in the case of divalent, it may be described as the 'group name' of the corresponding valence such as pyrimidinylene (group). Therefore, in the disclosure, when the type of the substituent is specified with the name of the parent compound, it may mean an n-valent 'group' formed by detachment of the hydrogen atom bonded to a carbon atom and/or a heteroatom of the parent compound.

Further, in this specification, numbers or alphabets indicating positions may be omitted when describing compound names or substituent names. For example, pyrido[4,3-d]pyrimidine may be simply referred to as pyridopyrimidine, benzofuro[2,3-d]pyrimidine as benzofuropyrimidine, and 9,9-dimethyl-9H-fluorene as dimethylfluorene. Therefore, both benzo[g]quinoxaline and benzo[f]quinoxaline may be described as benzoquinoxaline.

Further, unless explicitly stated, the chemical formulas used in this application apply the same substituent definitions as the index definitions of the following chemical formulas.

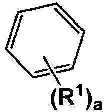

Here, when a is an integer of 0, it means that substituent R¹ is not present, that is, when a is 0, it means that hydrogen is bonded to all carbons forming the benzene ring, and in this case, the chemical formula or compound may be described by omitting the display of hydrogen bonded to carbon. Further, when a is an integer of 1, one substituent R¹ is bonded to any one carbon among the carbons forming the benzene ring and, when a is an integer of 2 or 3, e.g., it may be bonded as follows and, when a is an integer of 4 to 6, it is bonded to the carbon of the benzene ring in a similar manner and, when a is an integer of 2 or more, R¹ may be the same or different from each other.

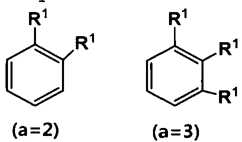

Unless otherwise described in this application, forming a ring means that adjacent groups bond to each other to form a single ring or fused multi-rings, and the single ring and formed fused multi-rings include not only hydrocarbon rings but also heterocycles including at least one heteroatom, and may include aromatic and non-aromatic rings.

Further, unless otherwise described in this specification, when indicating a condensed ring, the number in 'number-condensed ring' indicates the number of rings being condensed. For example, forms in which three rings are condensed with each other, such as anthracene, phenanthrene, and benzoquinazoline, may be denoted as 3-condensed rings.

Meanwhile, the term "bridged bicyclic compound" used in this application refers to a compound in which two rings share three or more atoms to form a ring, unless otherwise described. In this case, the shared atoms may include carbon or heteroatoms.

In this application, an organic electric device may mean component(s) between an anode and a cathode, or an organic light emitting diode or organic light emitting display device including an anode and a cathode and component(s) located therebetween.

Further, in some cases, the display device in this application may mean an organic electric device, an organic light emitting diode, and a panel including the same, or an electronic device including a panel and a circuit. Here, e.g., the electronic device may include all of lighting devices, solar cells, portable or mobile terminals (e.g., smartphones, tablets, PDAs, electronic dictionaries, PMPs, etc.), navigation terminals, game machines, various TVs, various computer monitors, etc., and is not limited thereto, and may be any type of device as long as it includes component(s).

Hereinafter, embodiments of the disclosure are described in detail. However, the scope of the disclosure is not limited to the embodiments disclosed herein but is defined by the appended claims.

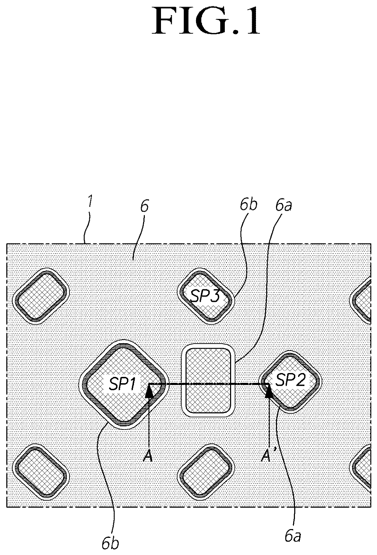

FIG. 1 is a partial plan view illustrating an organic light emitting display device according to an embodiment.

Referring to FIG. 1, an organic light emitting display device 20 according to an embodiment includes different organic light emitting elements SP1, SP2, SP3 disposed on a substrate 1. These different organic light emitting elements SP1, SP2, SP3 may be RGB subpixels, and these may constitute one pixel.

The different organic light emitting elements SP1, SP2, SP3 may have different areas, but may also have the same areas.

The organic light emitting display device 20 may include a pixel definition layer or pixel definition film, bank (hereinafter referred to as pixel definition layer 6) in which an organic material layer is disposed between two electrodes and exposes a portion of one of the electrodes through an opening 6d. As described above, the different organic light emitting elements SP1, SP2, SP3 may have different areas due to different areas of the opening 6d of the pixel definition layer 6.

The pixel definition layer 6 includes a photosensitive composition as described below and includes a halftone layer 6b, a trench 6a formed in the halftone layer 6b, and a full-tone layer 6c protruding from the halftone layer 6a. The trench 6a is disposed around the organic light emitting elements SP1, SP2, SP3. The full-tone layer 6c is disposed only in some of the organic light emitting elements. The halftone layer 6b is disposed over the entire substrate 1 except for the halftone layer 6b and the full-tone layer 6c.

The organic light emitting display device 20 according to an embodiment may arrange the trench 6a in the pixel definition layer 6, and the trench 6a has high lateral resistance to prevent lateral current flowing into the organic light emitting elements SP1, SP2, SP3, thereby not only making the display colors clear but also enhancing reliability and lifespan.

Further, the organic light emitting display device 20 according to an embodiment may prevent damage to the display by disposing the full-tone layer 6c in the pixel definition layer 6 to function as a spacer for pressure applied to other components disposed on the upper surface, e.g., a touch pad.

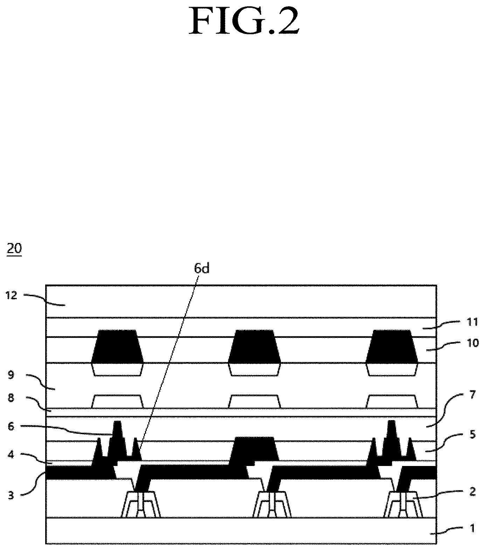

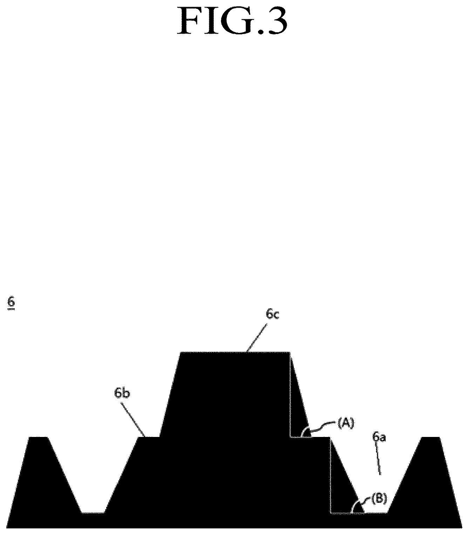

FIG. 2 is a cross-sectional view illustrating an organic light emitting display device according to an embodiment. FIG. 3 is a cross-sectional view along line A-A' of the pixel definition layer of FIG. 1.

Referring to FIGS. 2 and 3, an organic light emitting display device 20 according to an embodiment includes a substrate 1, a TFT layer 2 on the substrate, a planarization layer 3 on the TFT layer 2, a first electrode or pixel electrode 4 on the planarization layer 3, an organic material layer 5 on the first electrode, and a second electrode or counter electrode 7 disposed on the organic material layer 5.

Further, the organic light emitting display device 20 according to an embodiment may include a sealing layer 8 disposed on the second electrode 7, a touch panel 9 disposed on the sealing layer 8, a color filter 10 disposed on the touch panel 9, an OCA layer 11 disposed on the color filter 10, and a cover glass layer 12 disposed on the OCA layer.

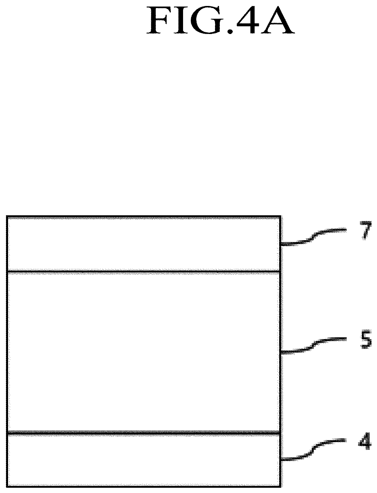

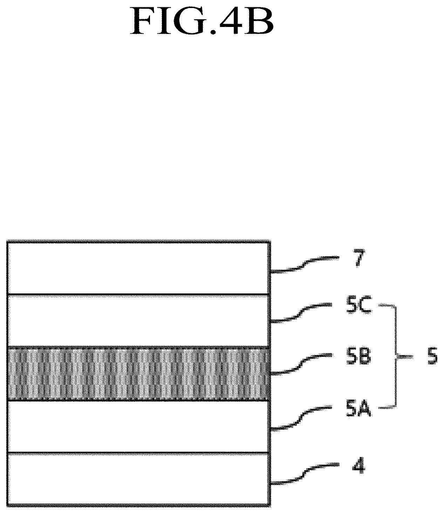

FIGS. 4A and 4B are cross-sectional views illustrating examples of organic material layers.

The organic material layer 5 may be composed of a single layer 5 between the first electrode 4 and the second electrode 7 as illustrated in FIG. 4A, or may be composed of a tandem structure including a first organic material layer 5A, a charge generation layer 5B on the first organic material layer 5A, and a second organic material layer 5C on the charge generation layer 5B as illustrated in FIG. 4B.

The pixel definition layer 6 may be disposed on the first electrode 4.

The pixel definition layer 6 includes a halftone layer 6b and a full-tone layer 6c, and a trench 6a may be disposed in the halftone layer 6b.

One or more trenches 6a may be formed adjacent to the organic material layer 5 in the halftone layer 6b.

The trench 6a formed in the halftone layer 6b may increase lateral resistance to prevent lateral current flowing into the organic material layer 5 through the pixel definition layer 6, thereby enhancing color reproduction rate, lifespan, and reliability of the organic light emitting element.

The substrate 1 may be a flexible substrate. The substrate 1 may be formed of plastic with excellent heat resistance and durability such as polyimide (PI), polyethylene terephthalate (PET), polyethylene naphthalate (PEN), polycarbonate (PC), polyarylate (PAR), polyetherimide (PEI), and polyethersulfone (PES) .

However, the disclosure is not limited thereto, and various flexible materials such as metal foil or thin glass may be used. Meanwhile, the substrate 1 may also be a rigid substrate, in which case the substrate may be formed of a glass material including SiO₂ as a main component.

In the case of a bottom emission type where an image is implemented in the direction of the substrate, the substrate should be formed of a transparent material. However, in the case of a top emission type where an image is implemented in the opposite direction of the substrate 1, the substrate 1 does not necessarily need to be formed of a transparent material. In this case, the substrate may be formed of metal. When forming the substrate with metal, the substrate 1 may include one or more selected from the group consisting of carbon, iron, chromium, manganese, nickel, titanium, molybdenum, and stainless steel (SUS), but the disclosure is not limited thereto.

A TFT layer 2 may be disposed on the substrate 1. The term TFT layer 2 mentioned in this specification collectively refers to a thin film transistor (TFT) array for driving an organic light emitting element, and means a driving portion for displaying an image. Only the organic light emitting element and the driving thin film transistor driving the organic light emitting element are illustrated in FIG. 1, which is for convenience of description, and the disclosure is not limited to what is illustrated, and it is apparent to those skilled in the art that a plurality of thin film transistors, storage capacitors, and various lines may be further included.

The TFT layer 2 may be covered and protected by a planarization layer 3. The planarization layer 3 may include an inorganic insulation film and/or an organic insulation film. Examples of inorganic insulation films that may be used for the planarization layer 3 include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), zirconium oxide (ZrO₂), barium strontium titanate (BST), lead zirconate-titanate (PZT), etc.

Further, examples of organic insulation films that may be used for the planarization layer 3 may include general-purpose polymers (PMMA, PS), polymer derivatives having phenolic groups, acrylic polymers, imide polymers, aryl ether polymers, amide polymers, fluoropolymers, p-xylene polymers, vinyl alcohol polymers, and blends thereof.

Meanwhile, the planarization layer 3 may have a composite laminate structure of an inorganic insulation film and an organic insulation film. Further, the planarization layer 3 may include the photosensitive composition of the disclosure. Since the matters regarding the photosensitive composition of the disclosure are the same as the contents according to an embodiment of the disclosure described above, they is omitted.

An organic material layer 5 may be formed on the planarization layer 3. The organic material layer 5 may include a first electrode 4 formed on the planarization layer, a second electrode or common electrode 7 disposed to face the first electrode, and an organic material layer 5 interposed therebetween. When voltage is applied between the first electrode 4 and the second electrode 7, the organic material layer 5 may emit light. The organic material layer 5 may emit red light, green light, blue light, or white light. When the organic material layer 5 emits white light, to represent a color image, or when the organic material layer 5 emits red light, green light, and blue light, to enhance color purity and light efficiency, the organic light emitting display device 23 may further include blue, green, and red color filters.

The organic light emitting display device 20 may be classified into a bottom emission type, a top emission type, and a dual emission type according to the light emission direction. In the bottom emission type organic light emitting display device 20, the first electrode 4 is provided as a light-transmitting electrode and the second electrode 7 is provided as a reflective electrode. In the top emission type organic light emitting display device 20, the first electrode 4 is provided as the second electrode 7 which is a reflective electrode, and the second electrode 7 is provided as a transflective electrode. In the disclosure, the organic light emitting display device 20 is described based on a top emission type that emits light in the direction of the sealing layer 8.

The first electrode 4 may be a reflective electrode. The first electrode 4 may include a laminate structure of a reflective layer and a transparent or semi-transparent electrode layer having a high work function. The reflective layer may include Ag, Mg, Al, Pt, Pd, Au, Ni, Nd, Ir, Cr, or alloys thereof. The transparent or semi-transparent electrode layer may include at least one material selected from transparent conductive oxide materials such as indium tin oxide (ITO), indium zinc oxide (IZO), zinc oxide (ZnO), indium oxide (In₂O₃), indium gallium oxide (IGO), and aluminum zinc oxide (AZO).

The first electrode may be formed by patterning in an island shape corresponding to each of the organic light emitting elements SP1, SP2, SP3.

Further, the first electrode 4 may function as an anode electrode.

Meanwhile, a pixel definition layer 6 including a predetermined opening 6d that covers the edge of the pixel electrode and exposes the central portion of the first electrode 4 may be disposed on the first electrode 4. An organic material layer 5 including an organic light emitting layer that emits light may be disposed on a region defined by the opening 6d. The region where the organic material layer 5 is disposed may be defined as a light emitting region.

Meanwhile, when a light emitting region is formed in the opening 6d of the pixel definition layer 6, a region protruding by the pixel definition layer 6 is disposed between the light emitting regions, and since an organic light emitting layer is not formed in this protruding region, it may be defined as a non-light emitting region. The pixel definition layer 6 may include the photosensitive composition of the disclosure.

A composition including a colorant according to an embodiment may be used to manufacture a red pattern, a green pattern, a blue pattern, or a black matrix, and a pixel definition layer 6.

A black pixel definition layer 6 according to an embodiment may further include an organic black pigment or black dye as an additional colorant other than the colorant included in the above-described colorant. For example, an organic pigment may be used alone, or an organic pigment and a coloring pigment may be mixed and used, and in this case, since a coloring pigment with insufficient light-blocking properties is mixed, there is an advantage that the strength of the film (layer) or adhesion to the substrate does not decrease even if the amount of colorant increases relatively. The pixel definition layer 6 according to an embodiment of the disclosure may include a black pigment or black dye as an additional colorant instead of the colorant included in the above-described colorant.

Hereinafter, each component is described in detail.

### I. Pixel Definition Layer

The pixel definition layer 6 of the disclosure includes a halftone layer 6b and a full-tone layer 6c composed of a photosensitive composition, and a trench 6a may be disposed in the halftone layer 6b.

The pixel definition layer 6 may prevent lateral current flowing into pixels due to high lateral resistance due to the presence of the trench 6a, so when applied to displays, colors are clear and the lifespan and reliability of the display may be enhanced.

FIG. 3 illustrates the taper angle B of the full-tone layer 6c and the taper angle A of the trench 6a.

The taper angle A of the trench 6a may be 50° to 80° or 60° to 70°, 63° to 67°, but the disclosure is not limited thereto.

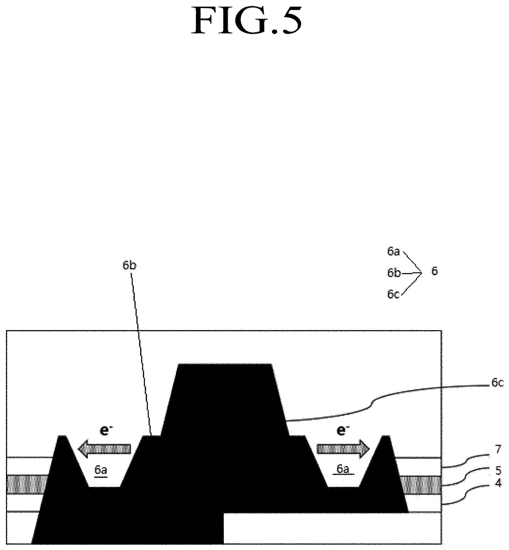

FIGS. 5 to 7 show the relationship between the taper angle of each layer of the pixel definition layer and lateral current in an organic light emitting display device according to an embodiment.

Referring to FIG. 5, the trench 6a of the pixel definition layer 6, regardless of the taper angle A, may effectively prevent lateral current flowing into the organic light emitting elements SP1, SP2, SP3, thereby enhancing the color reproduction rate and lifespan of the display.

In particular, when the taper angle A of the trench 6a of the pixel definition layer 6 is included within the range, it may effectively prevent lateral current flowing into the organic light emitting elements SP1, SP2, SP3, thereby enhancing the color reproduction rate and lifespan of the display.

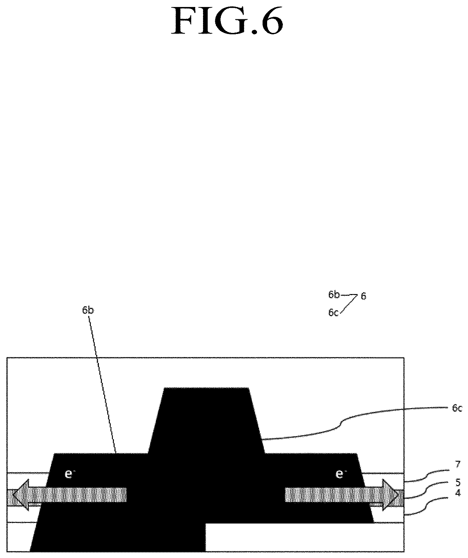

On the other hand, as illustrated in FIG. 6, when the trench 6a is not present or the taper angle A of the trench 6a is less than the range, the degree to which the trench 6a is substantially formed is minimal, so the effect of preventing lateral current is low, and the color reproduction rate and lifespan of the display may be relatively lowered.

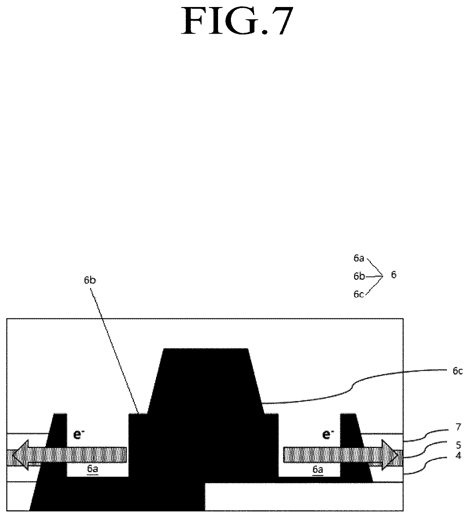

Further, as illustrated in FIG. 7, when the taper angle A of the trench 6a exceeds the range, the pixel definition layer 6 is formed relatively less, and lateral current easily flows into the organic light emitting elements SP1, SP2, SP3 through the electrode, which may lower the color reproduction rate and lifespan of the display as described above, and additionally, there is a high possibility of short circuit during deposition in the encapsulation process, which may cause panel defects.

The gap between the halftone layer 6b and the lowermost portion of the trench 6a may be 0.1 µm to 1.2 µm and may be 0.3 µm to 1.0 µm.

When the gap between the halftone layer 6b and the lowermost portion of the trench 6a is included within the range, sufficient empty space is present due to the trench 6a, so lateral resistance increases and accordingly lateral current flowing into the organic light emitting elements SP1, SP2, SP3 is effectively prevented, resulting in high color reproduction rate, lifespan, and reliability of the display.

The taper angle B of the full-tone layer 6c may be 15° to 40° or 20° to 35°, 25° to 30°, but the disclosure is not limited thereto.

The thickness of the halftone layer 6b may be 1.0 µm to 2.0 µm or 1.3 µm to 1.7 µm, but the disclosure is not limited thereto.

The thickness of the full-tone layer 6c may be 0.8 µm to 1.7 µm or 1.0 µm to 1.5 µm, but the disclosure is not limited thereto.

The composition forming the photosensitive composition constituting the pixel definition layer 6 is as follows.

### (1) Patterning Resin

The patterning resin, which is a photosensitive composition constituting the pixel definition layer 6, may include an acrylic binder resin, a cardo-based binder resin, a polyimide-based resin, or a combination thereof.

The acrylic binder resin is a copolymer of a first ethylenically unsaturated monomer and a second ethylenically unsaturated monomer copolymerizable therewith, and is a resin including one or more acrylic repeating units.

The first ethylenically unsaturated monomer is an ethylenically unsaturated monomer including one or more carboxyl groups, and specific examples thereof include acrylic acid, methacrylic acid, maleic acid, itaconic acid, fumaric acid, or combinations thereof. The first ethylenically unsaturated monomer may be included in an amount of 5 to 50% by weight, for example 10 to 40% by weight, based on the total amount of the acrylic binder resin.

The second ethylenically unsaturated monomer includes aromatic vinyl compounds such as styrene, α-methylstyrene, vinyltoluene, and vinylbenzyl methyl ether; unsaturated carboxylic acid ester compounds such as methyl (meth)acrylate, ethyl (meth)acrylate, butyl (meth)acrylate, 2-hydroxyethyl (meth)acrylate, 2-hydroxybutyl (meth)acrylate, benzyl (meth)acrylate, cyclohexyl (meth)acrylate, and phenyl (meth)acrylate; unsaturated carboxylic acid amino alkyl ester compounds such as 2-aminoethyl (meth)acrylate and 2-dimethylaminoethyl (meth)acrylate; carboxylic acid vinyl ester compounds such as vinyl acetate; unsaturated carboxylic acid glycidyl ester compounds such as glycidyl (meth)acrylate; cyanide vinyl compounds such as (meth)acrylonitrile; unsaturated amide compounds such as (meth)acrylamide; or the like, and these may be used alone or in combination of two or more.

Specific examples of the acrylic binder resin include (meth)acrylic acid/benzyl methacrylate copolymer, (meth)acrylic acid/benzyl methacrylate/styrene copolymer, (meth)acrylic acid/benzyl methacrylate/2-hydroxyethyl methacrylate copolymer, (meth)acrylic acid/benzyl methacrylate/styrene/2-hydroxyethyl methacrylate copolymer, etc., but the disclosure is not limited thereto. These may be used alone or in combination of two or more. The weight average molecular weight of the acrylic binder resin may be 3,000 g/mol to 150,000 g/mol, for example 5,000 g/mol to 50,000 g/mol, for example 20,000 g/mol to 30,000 g/mol.

The cardo-based resin includes a repeating structure as illustrated in Chemical Formula 1 below.

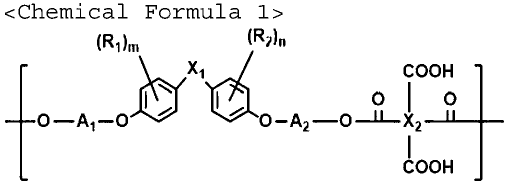

In Chemical Formula 1,
1) R¹ and R² are each independently hydrogen; deuterium; halogen; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C2-C20 alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
2) R¹ and R² may form a ring with adjacent groups,
3) m or n is independently an integer from 0 to 4,
4) A₁ and A₂ are each independently Chemical Formula 2 or Chemical Formula 3 below,

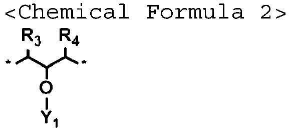

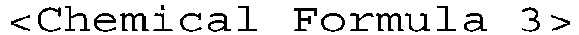

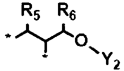

In Chemical Formulas 2 and 3,
4-1) * represents a connection site,
4-2) R³ to R⁶ are each independently hydrogen; deuterium; halogen; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C2-C20 alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-3) R³ to R⁶ may form a ring with adjacent groups,
4-4) Y¹ and Y² are each independently Chemical Formula 6 or Chemical Formula 7 below,

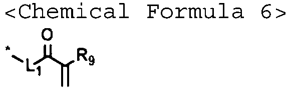

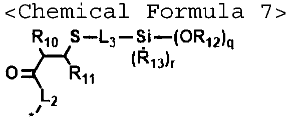

In Chemical Formulas 6 and 7,
4-4-1) * represents a bonding position,
4-4-2) R⁹ is hydrogen or methyl,
4-4-3) R¹⁰ to R¹³ are each independently hydrogen; deuterium; halogen; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C2-C20 alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-4-4) L¹ to L³ are each independently a single bond; a fluorenylene group; a C₂-C₃₀ alkylene; a C₆-C₃₀ arylene; a C₂-C₃₀ heterocycle; a C₁-C₃₀ alkoxylene; a C₂-C₃₀ alkyleneoxy; a C₆-C₃₀ aryloxy group; a C₂-C₃₀ polyethyleneoxy group,
4-4-5) q and r are each independently an integer from 0 to 3; provided that q+r=3,
5) The ratio of Formula 2 and Formula 3 in the polymer chain of the resin including the repeating unit represented by Chemical Formula 1 is 9:1 to 1:9,
6) X¹ is a single bond; O; CO; SO2; CR'R"; SiR'R"; Chemical Formula 4 below; or Chemical Formula 5,
6-1) R' and R" are each independently hydrogen; deuterium; halogen; a C₆-C₃₀ aryl group; a C₂-C3₀ heterocyclic group including at least one heteroatom among O, N, S, Si, and P; a C₆-C₃₀ fused ring group of aliphatic ring and aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-2) R' and R" may form a ring with adjacent groups,

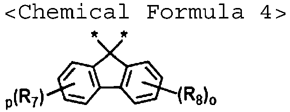

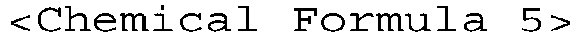

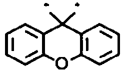

In Chemical Formulas 4 and 5,
6-3) * represents a bonding position,
6-4) R⁷ to R⁸ are each independently hydrogen; deuterium; halogen; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C2-C20 alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-5) o and p are each independently an integer of 0 to 4,
7) X² is a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; fluorenylene group; a carbonyl group; an ether group; or a C₁-C₂₀ alkoxycarbonyl group,
8) R' , R", X², L¹ to L³, R¹ to R⁸, and R¹⁰ to R¹³ may each be further substituted with one or more substituents selected from the group consisting of deuterium; halogen; a silane group substituted or unsubstituted with a C₁-C₃₀ alkyl group or a C₆-C₃₀ aryl group; a siloxane group; a boron group; a germanium group; a cyano group; an amino group; a nitro group; a C₁-C₃₀ alkylthio group; a C₁-C₃₀ alkoxy group; a C₆-C₃₀ arylalkoxy group; a C₁-C₃₀ alkyl group; a C₂-C₃₀ alkenyl group; a C₂-C₃₀ alkynyl group; a C₆-C₃₀ aryl group; a C₆-C₃₀ aryl group substituted with deuterium; a fluorenyl group; a C₂-C₃₀ heterocyclic group containing at least one heteroatom selected from the group consisting of O, N, S, Si, and P; a C₃-C₃₀ aliphatic cyclic group; a C₇-C₃₀ arylalkyl group; a C₈-C₃₀ arylalkenyl group; and combinations thereof, and adjacent substituents may form a ring.

When R', R", X², L¹ to L³, R¹ to R⁸, and R¹⁰ to R¹³ are aryl groups, they may be preferably C₆-C₃₀ aryl groups, more preferably C₆-C₁₈ aryl groups, for example phenyl, biphenyl, naphthyl, terphenyl, etc.

When R', R", X², L¹ to L³, R¹ to R⁸, and R¹⁰ to R¹³ are heterocyclic groups, they may be preferably C₂-C₃₀ heterocyclic groups, more preferably C₂-C₁₈ heterocyclic groups, for example dibenzofuran, dibenzothiophene, naphthobenzothiophene, naphthobenzofuran, etc.

When R', R", R¹ to R⁸, and R¹⁰ to R¹³ are fluorenyl groups, they may be preferably 9,9-dimethyl-9H-fluorene, 9,9-diphenyl-9H-fluorene group, 9,9'-spirobifluorene, etc.

When L¹ to L³ are arylene groups, they may be preferably C₆-C₃₀ arylene groups, more preferably C₆-C₁₈ arylene groups, for example phenyl, biphenyl, naphthyl, terphenyl, etc.

When R', R", X², R¹ to R⁸, and R¹⁰ to R¹³ are alkyl groups, they may preferably be C₁-C₁₀ alkyl groups, for example methyl, t-butyl, etc.

When R', R", X², R¹ to R⁸, and R¹⁰ to R¹³ are alkoxyl groups, they may be preferably C₁-C₂₀ alkoxyl groups, more preferably C₁-C₁₀ alkoxyl groups, for example methoxy, t-butoxy, etc.

The ring formed by adjacent groups of R', R", X², L¹ to L³, R¹ to R⁸, and R¹⁰ to R¹³ bonding with each other may be a C₆-C₆₀ aromatic ring group; a fluorenyl group; a C₂-C₆₀ heterocyclic group including at least one heteroatom among O, N, S, Si, and P; or a C₃-C₆₀ aliphatic ring group, and for example, when adjacent groups bond with each other to form an aromatic ring, they may preferably form a C₆-C₂₀ aromatic ring, more preferably a C₆-C₁₄ aromatic ring, for example benzene, naphthalene, phenanthrene, etc.

The cardo-based resin may be prepared by mixing two or more from, e.g., fluorene-including compounds such as 9,9-bis(4-oxiranylmethoxyphenyl)fluorene; anhydride compounds such as benzenetetracarboxylic dianhydride, naphthalenetetracarboxylic dianhydride, biphenyltetracarboxylic dianhydride, benzophenonetetracarboxylic dianhydride, pyromellitic dianhydride, cyclobutanetetracarboxylic dianhydride, perylenetetracarboxylic dianhydride, tetrahydrofurantetracarboxylic dianhydride, and tetrahydrophthalic anhydride; glycol compounds such as ethylene glycol, propylene glycol, and polyethylene glycol; alcohol compounds such as methanol, ethanol, propanol, n-butanol, cyclohexanol, and benzyl alcohol; solvent compounds such as propylene glycol methyl ethyl acetate and N-methylpyrrolidone; phosphorus compounds such as triphenylphosphine; and amine or ammonium salt compounds such as tetramethylammonium chloride, tetraethylammonium bromide, benzyldiethylamine, triethylamine, tributylamine, and benzyltriethylammonium chloride.

The weight average molecular weight of the cardo-based resin may be 1,000 to 100,000 g/mol, preferably 1,000 to 50,000 g/mol, more preferably 1,000 to 30,000 g/mol. When the weight average molecular weight of the resin is within the range, pattern formation is performed well without residues during light-shielding layer manufacturing, there is no loss of film thickness during development, and good patterns may be obtained. The resin may be included in an amount of 1 to 30% by weight, more preferably 3 to 20% by weight, based on the total amount of the photosensitive resin composition. When the resin is included within the range, excellent sensitivity, developability, and adhesion (adhesiveness) may be obtained.

The cardo-based resin and the acrylic resin may be mixed.

The resin mixture may be included in an amount of 1 to 50% by weight, more preferably 5 to 45% by weight, based on the total amount of the photosensitive composition. When the sum of the cardo-based resin and the acrylic resin is included within the range, the pixel definition layer 6 may obtain excellent sensitivity, developability, and adhesion (adhesiveness).

Further, the polyimide-based resin may be copolymerized with polyimide, which is the main structure of the polymer, to adjust solubility in order to prevent excessive dissolution characteristics in an alkaline aqueous solution of polyamic acid, which is a polyimide precursor, and an appropriate solubility difference between exposed and unexposed portions may be obtained during the pattern process, thereby implementing a black pixel partition layer with excellent heat resistance and pattern formability.

For example, the polyimide-based resin may include a polyamic acid repeating unit and a polyimide repeating unit, and the polyamic acid repeating unit and the polyimide repeating unit may be included in a molar ratio of 5:5 to 9:1, e.g., 2:8 to 8:2. When the polyamic acid repeating unit and the polyimide repeating unit are included in the molar ratio of the range, solubility in the solvent used in the composition may be secured, and appropriate developability may be illustrated in the patterning process. The polyimide-polyamic acid copolymer that may be used has a structure including Chemical Formula 1-1, Chemical Formula 1-2, or a combination thereof below.

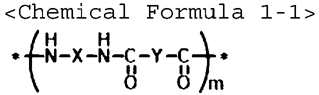

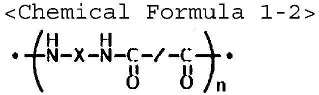

In Chₑₘical Formulas 1-1 aₙd ₁₋2,
1) * is a portion where bonds are connected as repeating units,
2) at the polymer terminal is a portion where Chemical Formulas Q1 to Q10 are bonded by amide bonds or imide bonds,
3) X is Chemical Formula 2 below,
4) Y is selected from the group consisting of a C₆-C₃₀ arylene group; a C₂-C₃₀ heterocyclic group containing at least one heteroatom among O, N, S, Si, and P; a C₆-C₃₀ fused ring group of an aliphatic ring and an aromatic ring; a C₁-C₂₀ alkylene group; a C₁-C₂₀ cycloalkylene group; a C₂-C₂₀ alkenylene group; a C₃-C₂₀ cycloalkenylene group; a C₂-C₂₀ alkynylene group; a C₃-C₂₀ cycloalkynylene group; Chemical Formula 2; and combinations thereof,
5) Z is selected from the group consisting of a C₆-C₃₀ arylene group; a C₂-C₃₀ heterocyclic group containing at least one heteroatom among O, N, S, Si, and P; a C₆-C₃₀ fused ring group of an aliphatic ring and an aromatic ring; a C₁-C₂₀ alkylene group; a C₁-C₂₀ cycloalkylene group; a C₂-C₂₀ alkenylene group; a C₃-C₂₀ cycloalkenylene group; a C₂-C₂₀ alkynylene group; a C₃-C₂₀ cycloalkynylene group; Chemical Formula 3; and combinations thereof,
6) m and n are integers of 1 or more, 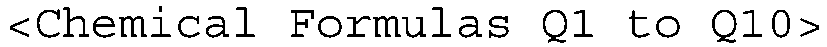 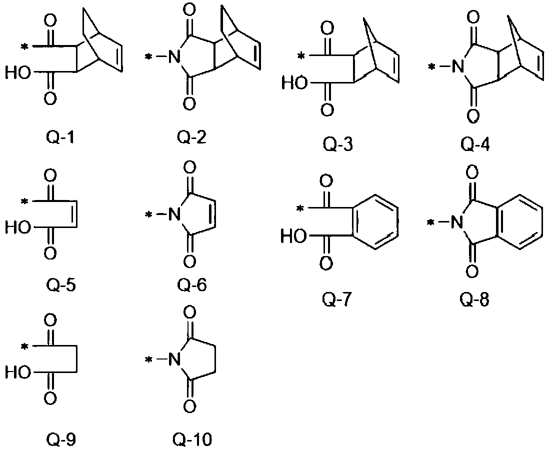 7) The polymer terminal is bonded by amide or imide bonds with chemical formulas selected from Chemical Formulas Q-1 to Q-10 or combinations thereof,

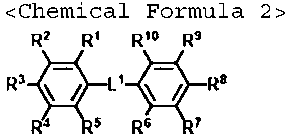

In Chemical Formula 2,
8) L¹ is selected from the group consisting of a single bond, -CH₂-, -CH₂CH₂-, -CH₂OCH₂-, -CH(CH₃)-, -C(CH₃)₂-, -O-, - CH(CF₃)-, -C(CF₃)₂-, -S-, -SO₂-, Si(CH₃)₂-, -C₆H₄-, -CO-, -NHCO-, - COO-,
9) Two of R¹ to R¹⁰ are connection sites with the amide groups of Chemical Formulas 1-1 and 1-2,
10) The remaining R¹ to R¹⁰ excluding the connection sites are each independently hydrogen; deuterium; hydroxyl group; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; a carboxyl group; or a C₁-C₂₀ alkoxycarbonyl group,
11) When L¹ is a single bond, adjacent R¹ and R¹⁰ that are not connection sites; and R⁵ and R⁶ may form a ring,

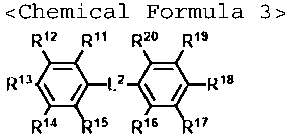

In Chemical Formula 3,
12) L² is selected from the group consisting of a single bond, -CH₂-, -CH₂CH₂-, -CH₂OCH₂-, -CH(CH₃)-, -C(CH₃)₂-, -O-, - CH(CF₃)-, -C(CF₃)₂-, -S-, -SO₂-, Si(CH₃)₂-, -C₆H₄-, -CO-, -NHCO-, - COO-,
13) Two of R¹¹ to R²⁰ are connection sites with the amide groups of Chemical Formulas 1-1 and 1-2,
14) The remaining R¹¹ to R²⁰ excluding the connection sites are each independently hydrogen; deuterium; hydroxyl group; a C₆-C₃₀ aryl group; a C₂-C₃₀ heterocyclic group including at least one heteroatom among O, N, S, Si, and P; a C₆-C₃₀ fused ring group of aliphatic ring and aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; a carboxyl group; or a C₁-C₂₀ alkoxycarbonyl group, provided that two of the remaining R¹¹ to R²⁰ excluding the connection sites are carboxyl groups,
15) When L² is a single bond, adjacent R¹¹ and R²⁰ that are not connection sites; and R¹⁵ and R¹⁶ may form a ring.

The polyimide-based resin is preferably prepared from a diamine monomer; a diacyl chloride monomer; and a dianhydride monomer.

The diamine preferably includes one or more monomers selected from the group consisting of 2,2'-bis(3-amino-4-hydroxyphenyl)hexafluoropropane, 2,2'-bis(3-amino-4-hydroxyphenyl) propane, 3,3'-dihydroxybenzidine, and combinations thereof.

The diacyl chloride preferably includes one or more monomers selected from the group consisting of 4,4'-oxybisbenzoyl chloride, 1,2-cyclobutanedicarboxylic acid dichloride, 1,4-cyclohexanedicarboxylic acid dichloride, and combinations thereof.

The dianhydride preferably includes one or more monomers selected from the group consisting of 4,4'-(hexafluoroisopropylidene)diphthalic anhydride, bicyclooctanetetracarboxylic dianhydride, and combinations thereof.

The weight average molecular weight of the resin is preferably 5,000 to 40,000 g/mol.

The polyimide-based resin is preferably included in an amount of 5 to 50% by weight based on the total amount of the composition.

### (2) Reactive Unsaturated Compound

The reactive unsaturated compound essential for negative patterns has ethylenically unsaturated double bonds, which may cause sufficient polymerization during exposure in the pattern formation process to form patterns with excellent heat resistance, light resistance, and chemical resistance.

Specific examples of reactive unsaturated compounds include ethylene glycol diacrylate, ethylene glycol dimethacrylate, diethylene glycol diacrylate, triethylene glycol diacrylate, triethylene glycol dimethacrylate, 1,6-hexanediol diacrylate, 1,6-hexanediol dimethacrylate, pentaerythritol triacrylate, dipentaerythritol pentaacrylate, dipentaerythritol hexaacrylate (Miramer M600, Miwon Specialty Chemical Co.), bisphenol A epoxy acrylate, ethylene glycol monomethyl ether acrylate, trimethylolpropane triacrylate, tripentaerythritol octaacrylate, etc.

Examples of commercially available reactive unsaturated compounds are as follows.

Examples of difunctional esters of (meth)acrylic acid include Aronix M-210, M-240, M-6200, etc. from Toagosei Chemical Industry Co., Ltd.; KAYARAD HDDA, HX-220, R-604, etc. from Nippon Kayaku Co., Ltd.; and V-260, V-312, V-335 HP, etc. from Osaka Organic Chemical Industry Co., Ltd.

Examples of trifunctional esters of (meth)acrylic acid include Aronix M-309, M-400, M-405, M-450, M-7100, M-8030, M-8060, etc. from Toagosei Chemical Industry Co., Ltd.; KAYARAD TMPTA, DPCA-20, DPCA-60, DPCA-120, etc. from Nippon Kayaku Co., Ltd.; and V-295, V-300, V-360, etc. from Osaka Organic Chemical Industry Co., Ltd.

The products may be used alone or in combination of two or more.

The reactive unsaturated compound may be treated with an acid anhydride to provide better developability. The reactive unsaturated compound may be included in an amount of 1 to 40% by weight, for example 1 to 20% by weight, based on the total amount of the photosensitive resin composition. When the reactive unsaturated compound is included within the range, sufficient curing occurs during exposure in the pattern formation process, resulting in excellent reliability, and the pattern has excellent heat resistance, light resistance, and chemical resistance, as well as excellent resolution and adhesion.

### (3) Photoinitiator

To implement negative patterns by photolithography, a photoradical initiator should be used.

The photopolymerization initiator is an initiator generally used in photosensitive resin compositions, and for example, acetophenone-based compounds, benzophenone-based compounds, thioxanthone-based compounds, benzoin-based compounds, triazine-based compounds, oxime-based compounds, or mixtures thereof may be used.

Examples of acetophenone-based compounds may include 2,2'-diethoxyacetophenone, 2,2'-dibutoxyacetophenone, 2-hydroxy-2-methylpropiophenone, p-t-butyltrichloroacetophenone, p-t-butyldichloroacetophenone, 4-chloroacetophenone, 2,2'-dichloro-4-phenoxyacetophenone, 2-methyl-1-(4-(methylthio)phenyl)-2-morpholinopropan-1-one, 2-benzyl-2-dimethylamino-1-(4-morpholinophenyl)-butan-1-one, etc.

Examples of benzophenone-based compounds may include benzophenone, benzoyl benzoic acid, methyl benzoyl benzoate, 4-phenyl benzophenone, hydroxy benzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, 3,3'-dimethyl-2-methoxybenzophenone, etc.

Examples of the thioxanthone-based compound may include thioxanthone, 2-chlorothioxanthone, 2-methylthioxanthone, isopropyl thioxanthone, 2,4-diethyl thioxanthone, 2,4-diisopropyl thioxanthone, and 2-chlorothioxanthone.

Examples of benzoin-based compounds may include benzoin, benzoin methyl ether, benzoin ethyl ether, benzoin isopropyl ether, benzoin isobutyl ether, benzyl dimethyl ketal, etc.

Examples of triazine-based compounds may include 2,4,6-trichloro-s-triazine, 2-phenyl 4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl 4,6-bis(trichloromethyl)-s-triazine, bis(trichloromethyl)-6-styryl-s-triazine, 2-(naphthol-yl)-4,6-bis(trichloromethyl)-s-triazine, 2-(4-methoxynaphthol-yl)-4,6-bis(trichloromethyl)-s-triazine, 2-4-trichloromethyl(piperonyl)-6-triazine, 2-4-trichloromethyl (4'-methoxystyryl)-6-triazine, etc.

Examples of oxime-based compounds may include 2-(o-benzoyloxime)-1-[4-(phenylthio)phenyl]-1,2-octanedione, 1-(o-acetyloxime)-1-[9-ethyl-6-(2-methylbenzoyl)-9H-carbazol-3-yl]ethanone, (E)-1(((3-cyclopentyl-1-(9-ethyl-6-(2-methylbenzoyl)-9H-carbazol-3-yl)propylidene)amino)oxy)ethan-1-one (PBG-304, Trony), etc.

In addition to the compounds, the photoinitiator may use carbazole-based compounds, diketone compounds, sulfonium borate-based compounds, diazo-based compounds, imidazole-based compounds, non-imidazole-based compounds, etc.

The photoinitiator may use peroxide-based compounds, azobis-based compounds, etc. as radical polymerization initiators.

Examples of peroxide-based compounds may include ketone peroxides such as methyl ethyl ketone peroxide, methyl isobutyl ketone peroxide, cyclohexanone peroxide, methylcyclohexanone peroxide, and acetylacetone peroxide; diacyl peroxides such as isobutyryl peroxide, 2,4-dichlorobenzoyl peroxide, o-methylbenzoyl peroxide, and bis-3,5,5-trimethylhexanoyl peroxide; hydroperoxides such as 2,4,4-trimethylpentyl-2-hydroperoxide, diisopropylbenzene hydroperoxide, cumene hydroperoxide, and t-butyl hydroperoxide; dialkyl peroxides such as dicumyl peroxide, 2,5-dimethyl-2,5-di(t-butylperoxy)hexane, 1,3-bis(t-butoxyisopropyl)benzene, and t-butylperoxyvaleric acid n-butyl ester; alkyl peresters such as 2,4,4-trimethylpentyl peroxyphenoxyacetate, α-cumyl peroxyneodecanoate, t-butyl peroxybenzoate, and di-t-butyl peroxytrimethyl adipate; and percarbonates such as di-3-methoxybutyl peroxydicarbonate, di-2-ethylhexyl peroxydicarbonate, bis-4-t-butylcyclohexyl peroxydicarbonate, diisopropyl peroxydicarbonate, acetylcyclohexylsulfonyl peroxide, and t-butyl peroxyallyl carbonate.

Examples of azobis-based compounds may include 1,1'-azobiscyclohexane-1-carbonitrile, 2,2'-azobis(2,4-dimethylvaleronitrile), 2,2'-azobis(methyl isobutyrate), 2,2'-azobis(4-methoxy-2,4-dimethylvaleronitrile), α,α'-azobis(isobutylnitrile), and 4,4'-azobis(4-cyanovaleric acid).

The photoinitiator may be used together with a photosensitizer that absorbs light to become excited and then transfers its energy to cause a chemical reaction. Examples of photosensitizers may include tetraethylene glycol bis-3-mercaptopropionate, pentaerythritol tetrakis-3-mercaptopropionate, dipentaerythritol tetrakis-3-mercaptopropionate, etc.

The photoinitiator may be included in an amount of 0.01 to 10% by weight, for example 0.1 to 5% by weight, based on the total amount of the photosensitive composition. When the photoinitiator is included within the range, sufficient curing occurs during exposure in the pattern formation process to obtain excellent reliability, the pattern has excellent heat resistance, light resistance, and chemical resistance, and resolution and adhesion are also excellent, and a decrease in transmittance due to unreacted initiator may be prevented.

### (4) Colorant

As colorants, organic pigments, inorganic pigments, and dyes may all be used.

As colorants, red pigments, green pigments, blue pigments, yellow pigments, black pigments, etc. may be used.

Examples of red pigments may include C.I. Pigment Red 254, C.I. Pigment Red 255, C.I. Pigment Red 264, C.I. Pigment Red 270, C.I. Pigment Red 272, C.I. Pigment Red 177, C.I. Pigment Red 89, etc.

Examples of green pigments may include halogen-substituted copper phthalocyanine pigments such as C.I. Pigment Green 36, C.I. Pigment Green 7, etc.

Examples of blue pigments may include copper phthalocyanine pigments such as C.I. Pigment Blue 15:6, C.I. Pigment Blue 15, C.I. Pigment Blue 15:1, C.I. Pigment Blue 15:2, C.I. Pigment Blue 15:3, C.I. Pigment Blue 15:4, C.I. Pigment Blue 15:5, C.I. Pigment Blue 16, etc.

Examples of yellow pigments may include isoindoline-based pigments such as C.I. Pigment Yellow 139; quinophthalone-based pigments such as C.I. Pigment Yellow 138; nickel complex pigments such as C.I. Pigment Yellow 150, etc.

Examples of black pigments may include lactam black, aniline black, perylene black, titanium black, carbon black, etc.

Further, the colorant in the photosensitive resin composition according to an embodiment may include pigments, dyes, or combinations thereof. For example, the dye may include phthalocyanine-based compounds.

Pigments and dyes may be used alone or in combination of two or more, and are not limited to these examples.

Among these, black pigments may be used to efficiently perform light blocking of the light-shielding layer. When using black pigments, they may be used together with color correcting agents such as anthraquinone-based pigments, perylene-based pigments, phthalocyanine-based pigments, and azo-based pigments.

A dispersant may be used together to disperse the pigment in the photosensitive resin composition. Specifically, the pigment may be surface-treated with a dispersant in advance, or the dispersant may be added together with the pigment during the preparation of the photosensitive resin composition.

As dispersants, nonionic dispersants, anionic dispersants, cationic dispersants, etc. may be used. Specific examples of dispersants may include polyalkylene glycol and its esters, polyoxyalkylene, polyhydric alcohol ester alkylene oxide adducts, alcohol alkylene oxide adducts, sulfonic acid esters, sulfonates, carboxylic acid esters, carboxylates, alkylamide alkylene oxide adducts, alkylamines, etc., and these may be used alone or in combination of two or more.

Examples of commercially available dispersants may include DISPERBYK-101, DISPERBYK-130, DISPERBYK-140, DISPERBYK-160, DISPERBYK-161, DISPERBYK-162, DISPERBYK-163, DISPERBYK-164, DISPERBYK-165, DISPERBYK166, DISPERBYK-170, DISPERBYK-171, DISPERBYK-182, DISPERBYK-2000, DISPERBYK-2001, etc. from BYK; EFKA-47, EFKA-47EA, EFKA-48, EFKA-49, EFKA-100, EFKA-400, EFKA-450, etc. from EFKA Chemical; Solsperse 5000, Solsperse 12000, Solsperse 13240, Solsperse 13940, Solsperse 17000, Solsperse 20000, Solsperse 24000GR, Solsperse 27000, Solsperse 28000, etc. from Zeneka; or PB711, PB821, etc. from Ajinomoto.

The dispersant may be included in an amount of 0.1 to 15% by weight based on the total amount of the photosensitive resin composition. When the dispersant is included within the range, the composition has excellent dispersibility, and thus has excellent stability, developability, and patternability when manufacturing the light-shielding layer.

The pigment may be pretreated using water-soluble inorganic salts and wetting agents. When the pigment is pretreated and used, the average particle size of the pigment may be refined.

The pretreatment may be performed through a step of kneading the pigment with water-soluble inorganic salts and wetting agents, and a step of filtering and washing the pigment obtained in the kneading step.

Kneading may be performed at a temperature of 40°C to 100°C, and filtering and washing may be performed by washing inorganic salts with water and then filtering.

Examples of water-soluble inorganic salts include sodium chloride, potassium chloride, etc., but the disclosure is not limited thereto.

The wetting agent serves as a medium that allows the pigment and water-soluble inorganic salts to mix uniformly so that the pigment may be easily pulverized. Examples include alkylene glycol monoalkyl ethers such as ethylene glycol monoethyl ether, propylene glycol monomethyl ether, and diethylene glycol monomethyl ether; alcohols such as ethanol, isopropanol, butanol, hexanol, cyclohexanol, ethylene glycol, diethylene glycol, polyethylene glycol, and glycerin polyethylene glycol; and these may be used alone or in combination of two or more.

The pigment that has gone through the kneading step may have an average particle size of 20 nm to 110 nm. When the average particle size of the pigment is within the range, it is possible to effectively form fine patterns while having excellent heat resistance and light resistance.

The pigment may be included in an amount of 1 to 40% by weight, more specifically 2 to 30% by weight, based on the total amount of the photosensitive resin composition. When the pigment is included within the range, the color reproduction rate is excellent, and the curability and adhesion of the pattern are excellent.

### (5) Solvent

As the solvent, materials that have compatibility with the cardo-based resin, reactive unsaturated compound, pigment, cardo-based compound, and initiator but do not react may be used.

Examples of solvents may include alcohols such as methanol and ethanol; ethers such as dichloroethyl ether, n-butyl ether, diisoamyl ether, methylphenyl ether, and tetrahydrofuran; glycol ethers such as ethylene glycol monomethyl ether and ethylene glycol monoethyl ether; cellosolve acetates such as methyl cellosolve acetate, ethyl cellosolve acetate, and diethyl cellosolve acetate; carbitols such as methylethyl carbitol, diethyl carbitol, diethylene glycol monomethyl ether, diethylene glycol monoethyl ether, diethylene glycol dimethyl ether, diethylene glycol methylethyl ether, and diethylene glycol diethyl ether; propylene glycol alkyl ether acetates such as propylene glycol methyl ether acetate and propylene glycol propyl ether acetate; aromatic hydrocarbons such as toluene and xylene; ketones such as methyl ethyl ketone, cyclohexanone, 4-hydroxy-4-methyl-2-pentanone, methyl-n-propyl ketone, methyl-n-butyl ketone, methyl-n-amyl ketone, and 2-heptanone; saturated aliphatic monocarboxylic acid alkyl esters such as ethyl acetate, n-butyl acetate, and isobutyl acetate; lactic acid esters such as methyl lactate and ethyl lactate; oxyacetic acid alkyl esters such as methyl oxyacetate, ethyl oxyacetate, and butyl oxyacetate; alkoxyacetic acid alkyl esters such as methyl methoxyacetate, ethyl methoxyacetate, butyl methoxyacetate, methyl ethoxyacetate, and ethyl ethoxyacetate; 3-oxypropionic acid alkyl esters such as methyl 3-oxypropionate and ethyl 3-oxypropionate; 3-alkoxypropionic acid alkyl esters such as methyl 3-methoxypropionate, ethyl 3-methoxypropionate, ethyl 3-ethoxypropionate, and methyl 3-ethoxypropionate; 2-oxypropionic acid alkyl esters such as methyl 2-oxypropionate, ethyl 2-oxypropionate, and propyl 2-oxypropionate; 2-alkoxypropionic acid alkyl esters such as methyl 2-methoxypropionate, ethyl 2-methoxypropionate, ethyl 2-ethoxypropionate, and methyl 2-ethoxypropionate; 2-oxy-2-methylpropionic acid esters such as methyl 2-oxy-2-methylpropionate and ethyl 2-oxy-2-methylpropionate, monooxymonocarboxylic acid alkyl esters of 2-alkoxy-2-methylpropionic acid alkyl such as methyl 2-methoxy-2-methylpropionate and ethyl 2-ethoxy-2-methylpropionate; esters such as ethyl 2-hydroxypropionate, ethyl 2-hydroxy-2-methylpropionate, ethyl hydroxyacetate, and methyl 2-hydroxy-3-methylbutanoate; ketonic acid esters such as ethyl pyruvate, etc.

Further, high boiling point solvents such as N-methylformamide, N,N-dimethylformamide, N-methylformanilide, N-methylacetamide, N,N-dimethylacetamide, N-methylpyrrolidone, dimethyl sulfoxide, benzyl ethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl cellosolve acetate, etc. may also be used.

Among the solvents, considering compatibility and reactivity, glycol ethers such as ethylene glycol monoethyl ether; ethylene glycol alkyl ether acetates such as ethyl cellosolve acetate; esters such as ethyl 2-hydroxypropionate; carbitols such as diethylene glycol monomethyl ether; and propylene glycol alkyl ether acetates such as propylene glycol methyl ether acetate and propylene glycol propyl ether acetate may be used.

The solvent may be included in the remaining amount based on the total amount of the photosensitive resin composition, and specifically may be included in an amount of 40 to 90% by weight. When the solvent is included within the range, the photosensitive resin composition has an appropriate viscosity, resulting in excellent processability during pattern layer manufacturing.

### (6) Other Additives

The photosensitive composition may further include additives such as malonic acid; 3-amino-1,2-propanediol; silane-based coupling agents including vinyl groups or (meth)acryloxy groups; leveling agents; fluorine-based surfactants; silicone-based surfactants; radical polymerization initiators, etc. to prevent stains or spots during coating, enhance leveling performance, and prevent the generation of residues due to undevelopment.

For example, the photosensitive resin composition may further include a silane-based coupling agent having reactive substituents such as vinyl groups, carboxyl groups, methacryloxy groups, isocyanate groups, and epoxy groups to enhance adhesion to substrates.

Examples of silane-based coupling agents may include trimethoxysilyl benzoic acid, γ-methacryloxypropyl trimethoxysilane, vinyl triacetoxysilane, vinyl trimethoxysilane, γ-isocyanate propyl triethoxysilane, γ-glycidoxypropyl trimethoxysilane, β-epoxy cyclohexyl ethyltrimethoxysilane, etc., and these may be used alone or in combination of two or more.

The silane-based coupling agent may be included in an amount of 0.01 to 10 portions by weight based on 100 portions by weight of the photosensitive resin composition. When the silane-based coupling agent is included within the range, adhesion, storage properties, etc. are excellent.

Further, the photosensitive resin composition may further include a surfactant, e.g., a fluorine-based surfactant or a silicone-based surfactant, for coating enhancement and defect prevention effects as needed.

As fluorine-based surfactants, BM-1000, BM-1100, etc. from BM Chemie; Megafac F 142D, F 172, F 173, F 183, etc. from Dainippon Ink and Chemicals; Fluorad FC-135, FC-170C, FC-430, FC-431, etc. from Sumitomo 3M; Surflon S-112, S-113, S-131, S-141, S145, etc. from Asahi Glass; fluorine-based surfactants commercially available under names such as SH-28PA, SH-190, SH-193, SZ-6032, SF-8428, etc. from Toray Silicone may be used.

As silicone-based surfactants, silicone-based surfactants commercially available under names such as EFKA 3030, EFKA 3034, EFKA 3886, etc. from BASF; 3030, 3085, 3236, etc. from AFCONA; BYK-379, BYK-3550, BYK-3751, BYK-3754, etc. from BYK may be used.

The surfactant may be used in an amount of 0.001 to 5 portions by weight based on 100 portions by weight of the photosensitive resin composition. When the surfactant is included within the range, coating uniformity is ensured, no stains occur, and wettability to glass substrates is excellent. Further, the photosensitive resin composition may have a predetermined amount of other additives such as antioxidants and stabilizers added within a range that does not impair physical properties.

### II. Method for Manufacturing Organic Light Emitting Display Device

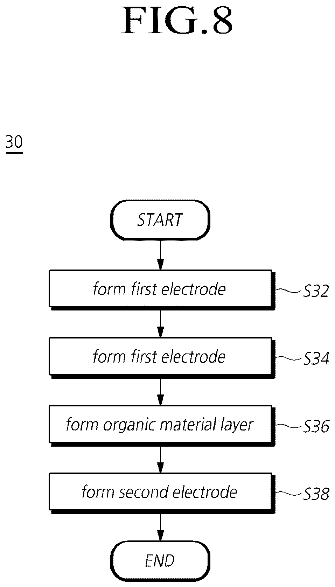

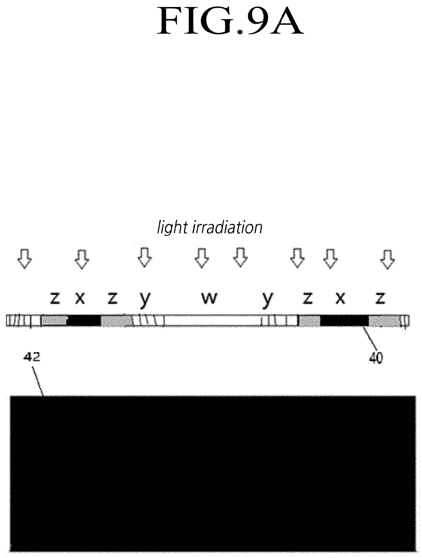

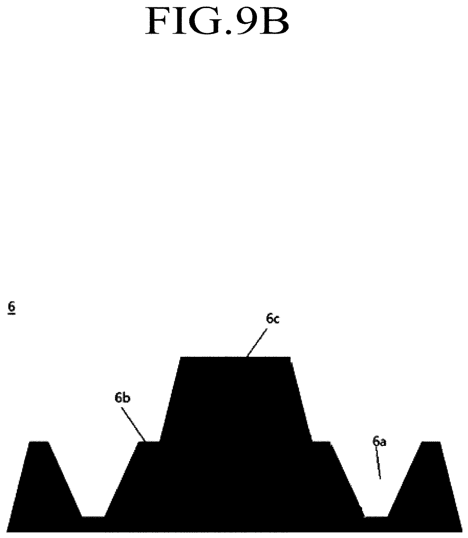

FIG. 8 is a flowchart illustrating a manufacturing method of an organic light emitting display device according to another embodiment. FIGS. 9A and 9B show processes of forming a pixel definition layer using a multi-tone photomask in the step of forming the pixel definition layer in the manufacturing method of FIG. 8.

Referring to FIGS. 1 and 8, a method 30 for manufacturing an organic light emitting display device 20 according to another embodiment includes preparing a first electrode 4 on a substrate 1 (S32), forming a pixel definition layer 6 on the first electrode 4 that exposes a portion of the first electrode 4 through an opening 6d (S34), forming an organic material layer 5 disposed in the opening 6d of the pixel definition layer 6 (S36), and forming a second electrode 7 disposed on the organic material layer 5 (S38).

Referring to FIGS. 9A and 9B, the step of forming the pixel definition layer 6 (S34) includes exposing a photosensitive composition 42 applied on the first electrode 4 using a photomask 40 including a first section x with 0% transmittance, a second section y with 5% to 20% transmittance, a third section z with 25% to 50% transmittance, and a fourth section w with 100% transmittance to form a trench 6a, a halftone layer 6b, and a full-tone layer 6c, respectively.

As described above, the taper angle A of the trench 6a may be 50° to 80° or 60° to 70°, 63° to 67°, and an appropriate taper angle A of the trench 6a may be formed by adjusting the transmittance of the second section y and the exposure time.

The gap between the halftone layer 6b and the lowermost portion of the trench 6a may be 0.1 µm to 1.2 µm and may be 0.3 µm to 1.0 µm, and an appropriate gap of the lowermost portion may be formed by adjusting the transmittance of the first to third sections x, y, z and the exposure time.

The taper angle B of the full-tone layer 6c may be 15° to 40° or 20° to 35°, 25° to 30°, and an appropriate taper angle B of the full-tone layer 6c may be formed by adjusting the transmittance of the fourth section w and the exposure time.

The thickness of the halftone layer 6b may be 1.0 µm to 2.0 µm or 1.3 µm to 1.7 µm, and an appropriate thickness of the halftone layer 6b may be formed by adjusting the transmittance of the second section y and the exposure time.

The thickness of the full-tone layer 6c may be 0.8 µm to 1.7 µm or 1.0 µm to 1.5 µm, and may be determined according to the thickness of the photosensitive composition itself.

In addition to the transmittance or exposure time of the sections described above, the above-described characteristics may be adjusted by the application and coating step, exposure step, shaping step, etc. described below.

In the example, using a negative photoresist as the photosensitive composition 42 to form the trench 6a, halftone layer 6b, and full-tone layer 6c was exemplarily described, but a positive photoresist may also be used. In this case, the first to fourth sections may have opposite transmittances to the example.

The step of forming the pixel definition layer 6 (S34) may include an application and coating step of applying and coating the photosensitive composition 42, an exposure step of exposing the photosensitive composition 42 using the photomask 40, and a developing step of developing the exposed photosensitive composition 42 at a temperature of 19°C to 27°C for 30 seconds to 120 seconds.

The step of forming the pixel definition layer (S34) may further include a pre-bake step.

Hereinafter, the step of forming the pixel definition layer 6 (S34) is described in detail.

### III. Method for Manufacturing Pixel Definition Layer

### (1) Application and Coating Step

The photosensitive composition 42 constituting the pixel definition layer 6 of the disclosure is a low-viscosity liquid sample, and a spin coater or slit coater is used to coat it to a predetermined thickness after application to a substrate. The spin coater has the advantage that the faster the rotation speed, the smaller the thickness, but the flatness deviation in the area is decreased, and for coating on large-area substrates, a slit coater is preferable to a spin coater. After coating, the surface exhibits fluidity due to the remaining solvent, which has the disadvantage of deteriorating flatness. To overcome this, VCD (vacuum chamber dry) is used to partially remove the solvent, thereby reducing fluidity on the surface.

### (2) Pre-bake Step

This is a process of heating the coated substrate at a predetermined temperature and time with a hot plate or oven to partially remove the solvent included in the coating film. If the surface or interior of the coating film is not dried, photomask contamination occurs during exposure in the next process and, when UV light is radiated, the exposed portion is not cured well, and the pattern is removed without being formed in the development process due to non-curing.

### (3) Exposure Step

After the pre-bake process, this is a process of curing the formed film by irradiating active rays (ultraviolet rays) using a patterned photomask 40. Types of lamps that generate active rays include LED lamps or metal (mercury) lamps, and wavelengths include g-line (436nm), h-line (405nm), i-line (365nm), and Deep UV (<260nm), which may be used individually or in combination.

### (4) Development Step

When irradiating active rays in the exposure step, they are divided into exposed and unexposed portions by the photomask 40. In the case of positive type, the exposed portion is dissolved by the developer and the unexposed portion resists the developer, leaving the pattern. In the case of negative type, the exposed portion is cured and has resistance to the developer, and the unexposed portion is developed. The black pixel definition layer (Black PDL) manufactured with the composition including the colorant of the disclosure is a negative type, and patterns may be formed by distinguishing between exposed portions (cured) and unexposed portions (developed).

It is preferable to use TMAH (tetramethylammonium hydroxide) 2.38wt% developer as the developer in the development step.

The development step is preferably performed at a temperature of 19°C to 27°C for 30 seconds to 120 seconds, preferably 30 seconds to 90 seconds, more preferably 30 seconds to 60 seconds.

In another embodiment, the pixel definition layer 6 manufactured using the above-described photosensitive composition 42 may be patterned on the pixel separation portion of the organic light emitting element electrode.

The second electrode 7 may be formed as a transmissive electrode. The second electrode 7 may be a transflective film thinly formed of metals with low work functions such as Li, Ca, LiF/Ca, LiF/Al, Al, Mg, and Ag. To compensate for the high resistance problem of thin metal transflective films, a transparent conductive film formed of transparent conductive oxide may be laminated on the metal transflective film.

The second electrode 7 may be formed over the entire substrate in the form of a common electrode.

Further, such a second electrode 7 may function as a cathode electrode.

The polarities of the pixel electrode and the second electrode 7 as described above may be opposite to each other.

The organic material layer 5 includes an organic light emitting layer that emits light, and the organic light emitting layer may use low molecular weight organic materials or high molecular weight organic materials. When the organic light emitting layer is a low molecular weight organic layer formed of low molecular weight organic materials, a hole transport layer (HTL) and a hole injection layer (HIL) may be disposed in the direction of the pixel electrode with the organic light emitting layer at the center, and an electron transport layer (ETL) and an electron injection layer (EIL) may be disposed in the direction of the second electrode 7.

Of course, the organic material layer 5 may have other functional layers laminated in addition to these hole injection layer, hole transport layer, electron transport layer, and electron injection layer. Further, as described above, the organic material layer 5 may be composed of a single layer 5 including functional layers as illustrated in FIG. 4A, or may be composed of a tandem structure including a first organic material layer 5A including functional layers, a charge generation layer 5B on the first organic material layer, and a second organic material layer 5C including functional layers on the charge generation layer as illustrated in FIG. 4B.

A sealing layer 8 may be disposed on the organic material layer 5 to cover the organic material layer 5. The organic light emitting element included in the organic material layer 5 is composed of organic materials and may be easily deteriorated by external moisture or oxygen. Therefore, the organic material layer 5 should be sealed to protect such organic light emitting elements. The sealing layer 8 may have a structure in which a plurality of inorganic films and a plurality of organic films are alternately laminated as a means of sealing the organic material layer 5.

In the organic light emitting display device of this embodiment, it is preferable to form the sealing layer 8 with a thin film in which a plurality of inorganic films and a plurality of organic films are alternately laminated rather than a sealing substrate, and using a thin film as a sealing means, flexibility and thinning of the organic light emitting display device may be easily implemented.

The sealing layer 8 may include a plurality of inorganic films and a plurality of organic films. The inorganic films and organic films may be alternately laminated with each other.

The inorganic films may be formed of metal oxide, metal nitride, metal carbide, or combinations thereof. For example, the inorganic films may be formed of aluminum oxide, silicon oxide, or silicon nitride. According to another example, the inorganic films may include a laminated structure of a plurality of inorganic insulation layers. The inorganic films may perform a function of suppressing the penetration of external moisture and/or oxygen into the organic light emitting element layer.

The organic films may be high molecular weight organic compounds. For example, the organic films may include any one of epoxy, acrylate, or urethane acrylate. The organic films may perform functions of relieving internal stress of the inorganic films, compensating for defects of the inorganic films, and planarizing.

The stacking order of the inorganic films and organic films constituting the sealing layer 8 is not limited, and an organic film or an inorganic film may be laminated on the organic material layer 5, and the uppermost layer of the sealing layer 8 may also be an organic film or an inorganic film.

A touch panel 9 may be formed on the sealing layer 8. The touch panel 9 may include a first touch electrode formed on the sealing layer 8, a second touch electrode disposed to face the first touch electrode, and an insulation layer interposed therebetween.

The first touch electrode and the second touch electrode may be formed in a lattice pattern or a specific pattern shape. The first touch electrode may be formed in contact with the upper portion of the sealing layer 8, and an inorganic layer may be additionally provided between the sealing layer 8 and the first touch electrode.

The first touch electrode and the second touch electrode may be formed of ITO or metal mesh, and it is preferable to be formed of metal mesh.

Metal mesh is an electrode manufactured by printing opaque metals (copper, silver, gold, aluminum, etc.) in a lattice form with a thickness of 1 to 7 µm. Since highly conductive metals are used, the resistance value is very low, so the touch response speed is fast, it is easy to implement large screens, and it has the advantage of being cheaper than ITO film. Further, metal mesh electrodes have excellent durability against repetitive bending compared to ITO electrodes, making them suitable for use as touch panel electrodes for foldable displays.

The touch panel 9 is preferably a capacitive touch panel that detects position by recognizing the portion where the amount of current has changed using the capacitance in the human body when a user touches and calculating the size.

The organic light emitting display device of the disclosure is not limited to what is illustrated, and it is obvious to those skilled in the art that it may further include a Control IC that converts analog signals transmitted from the touch panel into digital signals and controls coordinate values necessary for determining the coordinates of the touch area, optical clear adhesive, flexible printed circuit board (FPCB) on which conduction and signal line patterns are formed to transmit various signals to electronic components, and various other electronic components and various lines.

A color filter 10 may be formed on the touch panel 9. The color filter 10 is located on the touch panel 9 and may include a color portion vertically aligned with the light emitting region of the organic material layer 5 and a color separation portion vertically aligned with the non-light emitting region and separating the color portions.

The positions of each layer in the structure of the organic light emitting display device 20 described above are not limited, and it is obvious to those skilled in the art that various functional layers with specific purposes and functions may be additionally disposed between each layer, and the organic light emitting display device of the disclosure is not limited to the structure and drawings described above.

Hereinafter, synthesis examples and examples according to the disclosure is specifically described, but the synthesis examples and examples of the disclosure are not limited thereto.

### I. Preparation of Photosensitive Composition

### Synthesis Example 1: (Preparation of 9,9-Bis[4-(glycidyloxy)phenyl]fluorene of Chemical Formula 8)

20g of 9,9'-bisphenolfluorene (Sigma aldrich), 8.67g of glycidyl chloride (Sigma aldrich), and 30g of anhydrous potassium carbonate were disposed in a 300ml 3-neck round bottom flask equipped with 100ml of dimethylformamide and a distillation tube, heated to 80°C and reacted for 4 hours, then the temperature was lowered to 25°C, the reaction solution was filtered, and the filtrate was added dropwise to 1000ml of water with stirring. After precipitating the powder, it was filtered, washed with water, and dried under decreased pressure at 40°C to obtain 25g of 9,9-Bis[4-(glycidyloxy)phenyl]fluorene of Chemical Formula 8 below. The obtained powder showed 98% purity as a result of purity analysis by HPLC.

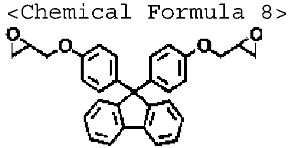

### Synthesis Example 2: Preparation of Cardo-based Binder Resin

25g (54mmol) of Compound 1 obtained in Synthesis Example 1, 8g of acrylic acid (Daejung Chemical), 0.2g of benzyltriethylammonium chloride (Daejung Chemical), and 0.2g of hydroquinone (Daejung Chemical) were disposed in a 300ml 3-neck round bottom flask equipped with a distillation tube together with 52g of propylene glycol methyl ether acetate (Sigma aldrich) and stirred at 110°C for 6 hours. After completion of the reaction, 8g of biphenyltetracarboxylic dianhydride (Mitsubishi Gas) and 1.8g of tetrahydrophthalic acid (Sigma aldrich) were added, and then stirred again at 110°C for 6 hours. After completion of the reaction, the reaction solution was recovered and analyzed to obtain a cardo-based binder resin with a molecular weight of 4,580 and a solid content of 45%.

### Synthesis Example 3: Preparation of Polyimide-based Resin

After installing a stirrer, nitrogen injection device, dropping funnel, temperature controller, and cooler in a 250ml 3-neck round bottom flask, filling with nitrogen and filling with 65.7g of N-methylpyrrolidone (NMP), 15g of 2,2'-bis(3-amino-4-hydroxyphenyl)hexafluoropropane and 0.52g of pyridine were added, and maintained at 40°C while stirring. 0.910g of phthalic anhydride was slowly added thereto, and then dissolved and reacted by stirring for a predetermined period of time. After adding 52.70g of NMP to the flask in which the reaction was in progress, the solution was stirred for 30 minutes while maintaining the temperature at 5°C. Thereafter, 11.18g of 4,4'-oxybisbenzoyl chloride was slowly added to dissolve it, and the reaction was carried out while stirring for 12 hours.

After stirring the polyhydroxyamide solution at room temperature for 1 hour, it was precipitated with 1506g of methanol, and the precipitated solid was dried in vacuum at 60°C for 12 hours to obtain 21.13g of copolymer polyimide-based resin powder.

### Preparation Example 1: Preparation of Black Pigment Dispersion

15g of Irgaphor Black S 100 CF (black pigment/BASF), 8.5g of Disperbyk 163 (BYK), and 6.5g of SR-3613 (SMS) were dispersed with 70g of propylene glycol methyl ether acetate and 100g of zirconia beads with a diameter of 0.5mm (Toray) using a paint shaker (Asada) for 10 hours to obtain a dispersion.

Photosensitive compositions were prepared with the compositions illustrated in Table 1 below.

Specifically, after dissolving the initiator in the solvent and stirring at room temperature, the binder resin and reactive unsaturated compound were added thereto and stirred at room temperature. Subsequently, the colorant and other additives were added to the obtained reaction product and stirred at room temperature. Subsequently, the product was filtered three times to remove impurities, thereby preparing photosensitive resin compositions A-1 to A-3 as illustrated in Table 1 below.

**[Table 1]**

| **Component** | **Composition (%)** | | | |
|---|---|---|---|---|
| | **A-1** | **A-2** | **A-3** | **A-4** |
| Black pigment dispersion (Preparation Example 1) | 23 | 23 | 23 | 23 |
| Cardo-based resin (Synthesis Example 2) | 15 | - | 11 | - |
| Acrylic resin (SR-3100, SMS) | - | 15 | 4 | - |
| Polyimide-based resin (Synthesis Example 3) | - | - | - | 15 |
| Reactive unsaturated compound (Miramer M600, Miwon Specialty Chemical) | 12.5 | 12.5 | 12.5 | 12.5 |
| Photoinitiator (PBG-304, Trony) | 0.5 | 0.5 | 0.5 | 0.5 |
| Solvent (propylene glycol methyl ether acetate) | 49 | 49 | 49 | 49 |

The acrylic resin (polymer C-1) was SR-3100 (SMS, resin including double bonds with an average molecular weight of 6,000 to 8,000), the reactive unsaturated compound was Miramer M600 (Miwon Specialty Chemical), the photoinitiator was PBG-304 (Trony), and the solvent was propylene glycol methyl ether acetate.

### II. Method for Manufacturing Pixel Definition Layer (PDL) and Measurement Examples

### (1) Application and Coating Step

The photosensitive composition is applied to a predetermined thickness on a washed 10cm*10cm metal-deposited substrate using a spin coater, and then a film is formed by partially removing the solvent using VCD (vacuum chamber dry). The coating thickness of the photosensitive composition forms a film with a thickness of 3.3 micrometers to 3.5 micrometers after VCD.

### (2) Pre-bake Step

To remove the solvent included in the obtained film, it is heated on a hot plate at 80°C to 150°C, preferably 90°C to 120°C, for 50 seconds to 200 seconds, preferably 60 seconds to 180 seconds, more preferably 100 seconds to 150 seconds. By removing a predetermined amount of solvent in this process, mask contamination in pixel form may be decreased during the next process (exposure) step, and clean patterns may be created.

### (3) Exposure Step

After interposing a mask in pixel form to obtain the necessary pattern formation and predetermined thickness in the obtained film, patterns may be formed by irradiating light sources of metal or LED lamps having active rays of 190 nm to 600 nm, preferably ghi-line, through an exposure machine. The exposure amount radiated for pattern formation is 20 to 150 mJ/cm², preferably 70 mJ/cm² to 140 mJ/cm², more preferably 80 to 110 mJ/cm², and it is a negative type photoresist material being formed. The transmittance of the photomask used during exposure has four sections of transmittance: 0% (unexposed area), 5% to 20% (trench), 25% to 50% (halftone), and 100% (full-tone) to form patterns. In the following examples, when forming the halftone layer, the exposure amount was set to x mJ/cm², the photomask transmittance was 35%, and trenches were formed by adjusting the photomask transmittance in the range of 5% to 20% as illustrated in Table 2.

### (4) Development Step

Following the exposure step, after developing by a dipping method with TMAH (tetramethylammonium hydroxide) 2.38wt% developer at 23±2°C for 30 seconds to 120 seconds, washing with ultrapure water (DI water) to dissolve and remove the unexposed portions, leaving only the exposed portions to form image patterns.

### (5) Pattern and Taper Angle Analysis

To identify the image pattern and taper angle obtained by development, the shape and thickness of the pattern cross-section were measured using a scanning electron microscope (JEOL), and the taper angle was identified by designating the top of the highest pattern from the bottom as the full-tone layer, the middle portion as the halftone layer, and the concave portion of the middle portion as the trench.

### (6) Lateral Resistance Measurement

To measure lateral resistance, a lateral current measurement module as illustrated in FIG. 3 below was constructed. The comparative examples are the same as the above-described examples but differ from the above-described examples in that the trench is not present, the taper angle of the trench is not in the appropriate range, or the halftone layer surface-trench lowermost portion gap is not in the appropriate range as illustrated in Table 2.

Describing the lateral current measurement module of FIG. 5 below, a pixel definition layer is formed on an organic light emitting display device composed of a first electrode or anode and a second electrode or cathode with a size of 5 µm × 5 µm in width (based on photomask) and 1.5 µm in full-tone thickness (based on actual measurement after firing) to configure halftone, trench, and full-tone, an ITO electrode layer is applied to the outer portion of the provided pixel definition layer, and a P-doped HTL layer without an ITO electrode layer is applied to the center to measure the lateral current value of the pixel definition layer.

For the lateral current value, an I-V curve was derived using the module for each example and comparative example. Further, a lateral resistance value was derived with Keithley 2400 for accurate measurement of lateral resistance according to the I-V value.

**[Table 2]**

| | **Photosensitive composition** | **Development time (s)** | **Trench photomask transmittance (%)** | **Trench taper angle (°)** | **Halftone layer surface-trench lowermost portion spacing (µm)** | **Lateral resistance (kΩ/nm)** |
|---|---|---|---|---|---|---|
| Example 1 | A-1 | 30 | 11 | 50 | 0.75 | 4744.2 |
| Example 2 | A-1 | 60 | 11 | 60 | 0.75 | 5421.6 |
| Example 3 | A-1 | 90 | 11 | 70 | 0.75 | 6423.2 |
| Example 4 | A-1 | 120 | 11 | 80 | 0.75 | 7331.2 |
| Example 5 | A-1 | 75 | 5 | 65 | 1.2 | 7532.1 |
| Example 6 | A-1 | 75 | 10 | 65 | 0.85 | 8206.1 |
| Example 7 | A-1 | 75 | 15 | 65 | 0.5 | 5320.1 |
| Example 8 | A-1 | 75 | 20 | 65 | 0.15 | 4224.4 |
| Example 9 | A-2 | 30 | 11 | 50 | 0.75 | 5078.5 |
| Example 10 | A-2 | 60 | 11 | 60 | 0.75 | 5955.4 |
| Example 11 | A-2 | 90 | 11 | 70 | 0.75 | 6389.7 |
| Example 12 | A-2 | 120 | 11 | 80 | 0.75 | 8830.4 |
| Example 13 | A-2 | 75 | 5 | 65 | 1.2 | 8324.2 |
| Example 14 | A-2 | 75 | 10 | 65 | 0.85 | 9232.1 |
| Example 15 | A-2 | 75 | 15 | 65 | 0.5 | 5766.1 |
| Example 16 | A-2 | 75 | 20 | 65 | 0.15 | 4753.1 |
| Example 17 | A-3 | 30 | 11 | 50 | 0.75 | 3421.2 |
| Example 18 | A-3 | 60 | 11 | 60 | 0.75 | 4213.5 |
| Example 19 | A-3 | 90 | 11 | 70 | 0.75 | 5063.5 |
| Example 20 | A-3 | 120 | 11 | 80 | 0.75 | 6721.3 |
| Example 21 | A-3 | 75 | 5 | 65 | 1.2 | 6232.5 |
| Example 22 | A-3 | 75 | 10 | 65 | 0.85 | 7021.3 |
| Example 23 | A-3 | 75 | 15 | 65 | 0.5 | 5723.2 |
| Example 24 | A-3 | 75 | 20 | 65 | 0.15 | 4015.6 |
| Example 25 | A-4 | 30 | 11 | 50 | 0.75 | 3924.3 |
| Example 26 | A-4 | 60 | 11 | 60 | 0.75 | 5554.3 |
| Example 27 | A-4 | 90 | 11 | 70 | 0.75 | 6323.4 |
| Example 28 | A-4 | 120 | 11 | 80 | 0.75 | 8012.2 |
| Example 29 | A-4 | 75 | 5 | 65 | 1.2 | 7532.4 |
| Example 30 | A-4 | 75 | 10 | 65 | 0.85 | 8232.4 |
| Example 31 | A-4 | 75 | 15 | 65 | 0.5 | 5499.1 |
| Example 32 | A-4 | 75 | 19 | 65 | 0.15 | 3721.1 |
| Comparative Example 1 | A-1 | 15 | 10 | 45 | 0.8 | 1108.1 |
| Comparative Example 2 | A-3 | 150 | 15 | 90 | 0.5 | 3100.3 |
| Comparative Example 3 | A-2 | 75 | 4 | 65 | 1.3 | 1201.3 |
| Comparative Example 4 | A-2 | 75 | - | - | 0 | 100.5 |

In Table 2, comparing the results of the examples with Comparative Examples 1 and 2, it may be identified that when the taper angle value of the trench is included within the range limited by the disclosure, the lateral resistance value is relatively high.

When the taper angle of the trench is included in the range limited by the disclosure, it is judged that the trench of the halftone layer may be present as sufficient empty space, thereby increasing resistance and effectively blocking the flow of charge, resulting in suppression of lateral current. On the other hand, when the taper angle of the trench is less than 50°, it is judged that the lateral current may not be efficiently blocked because the empty space is relatively small and there are many media through which charges may sufficiently flow.

Further, comparing the results of the examples with Comparative Examples 3 and 4, it may be identified that the lateral resistance value is relatively high even when the gap between the halftone layer and the trench lowermost portion is included within the range limited by the disclosure. In particular, referring to the results of Comparative Example 4 where no trench is formed, it may be identified that the examples with trenches formed have relatively high lateral resistance. This is judged to be a result of increased resistance and suppressed lateral current when the trench is present as sufficient empty space, similar to the taper angle comparison results.

Further, when the gap is 1.2 µm or more as in Comparative Example 3, it is judged that the pixel definition layer is present relatively thinly, resulting in decreased physical stability and thus failing to efficiently block lateral current.

Comparing the comparative examples with each other, Comparative Example 4 without a trench has a very low lateral resistance value, but Comparative Examples 1 to 3 have relatively higher lateral resistance values compared to Comparative Example 4.

When comparing the above-described examples and comparative examples, the organic light emitting display device, its manufacturing method, and its electronic device according to the above-described examples may increase lateral resistance by forming trenches in the pixel definition layer, and may relatively further increase lateral resistance because the trenches include taper angle values in an appropriate range.

In conclusion, the organic light emitting display device, its manufacturing method, and its electronic device according to the above-described examples form trenches in the pixel definition layer and the trenches include taper angle values in an appropriate range, resulting in high lateral resistance that prevents lateral current flowing into pixels, thereby not only making the display colors clear but also enhancing reliability and lifespan.

The above description is merely an example description of the present invention, and various changes may be made thereto without departing from the essential features of the present invention by one of ordinary skill in the art.

Therefore, the embodiments disclosed in this specification are not intended to limit the disclosure but to describe it, and the spirit and scope of the disclosure are not limited by these embodiments. The scope of protection of the disclosure should be interpreted by the claims, and all technologies within the equivalent scope should be interpreted as being included in the scope of the disclosure.

## Claims

1. An organic light emitting display device, comprising:
a first electrode;
a pixel definition layer disposed on the first electrode and exposing a portion of the first electrode through an opening;
an organic material layer disposed in the opening of the pixel definition layer; and
a second electrode disposed on the organic material layer, wherein the pixel definition layer includes a photosensitive composition and includes a halftone layer and a trench formed in the halftone layer, and a full-tone layer protruding from the halftone layer.

2. The organic light emitting display device of claim 1, wherein a taper angle of the trench is 50° to 80°.

3. The organic light emitting display device of claim 1, wherein the organic material layer has a tandem structure including two light emitting layers, and includes a touch pad on the second electrode.

4. The organic light emitting display device of claim 1, wherein a gap between the halftone layer and a lowermost portion of the trench is 0.1 µm to 1.2 µm.

5. The organic light emitting display device of claim 1, wherein a thickness of the halftone layer is 1.0 µm to 2.0 µm, and wherein a thickness of the full-tone layer is 0.8 µm to 1.7 µm.

6. The organic light emitting display device of claim 1, wherein the photosensitive composition includes an acrylic binder resin, a cardo-based binder resin, a polyimide-based resin, or a combination thereof.

7. The organic light emitting display device of claim 1, wherein the photosensitive composition includes a colorant.

8. The organic light emitting display device of claim 1, wherein the photosensitive composition includes a reactive unsaturated compound.

9. The organic light emitting display device of claim 1, wherein the photosensitive composition includes a photoinitiator.

10. A method for manufacturing an organic light emitting display device, the method comprising:
preparing a first electrode on a substrate;
forming a pixel definition layer on the first electrode, the pixel definition layer exposing a portion of the first electrode through an opening;
forming an organic material layer disposed in the opening of the pixel definition layer; and
forming a second electrode disposed on the organic material layer, wherein forming the pixel definition layer includes exposing a photosensitive composition applied on the first electrode using a photomask including a first section with 0% transmittance, a second section with 5% to 20% transmittance, a third section with 25% to 50% transmittance, and a fourth section with 100% transmittance to form a trench, a halftone layer, and a full-tone layer, respectively.

11. The method of claim 10, wherein a taper angle of the trench is 50° to 80°.

12. The method of claim 10, wherein forming the pixel definition layer includes: an applying and coating step of applying and coating the photosensitive composition; an exposing step of exposing the photosensitive composition using the photomask; and a developing step of developing the exposed photosensitive composition at a temperature of 19°C to 27°C for 30 seconds to 120 seconds.

13. The method of claim 12, wherein forming the pixel definition layer further includes a pre-bake step.

14. The method of claim 10, wherein the photosensitive composition includes an acrylic binder resin, a cardo-based binder resin, a polyimide-based resin, or a combination thereof.

15. The organic light emitting display device of claim 10, wherein the photosensitive composition includes a colorant and a reactive unsaturated compound, and the photosensitive composition includes a photoinitiator.
